# EUROPÄISCHE PATENTSCHRIFT

(11) **EP 2 638 634 B1**
(45) Veröffentlichungstag und Bekanntmachung des Hinweises auf die Patenterteilung: **16.12.2015**
(21) Anmeldenummer: 11771173.9
(22) Anmeldetag: 20.10.2011
(51) Int. Cl.: H03M 3/02, H03M 7/32

(54) **Delta-Sigma-D/A-Wandler**
Delta-sigma d/a converter
Convertisseur n/a delta-sigma

(30) Priorität: 12.11.2010 DE 102010043842
(43) Veröffentlichungstag der Anmeldung: 18.09.2013
(73) Patentinhaber: Endress+Hauser Wetzer GmbH+Co. KG, 87484 Nesselwang (DE)
(72) Erfinder: LUGLI, Robert, I-20090 Segrate (IT); KORN, Michael, 87616 Marktoberdorf (DE); ZOTZ, Alfred, 87648 Aitrang (DE); DAMITH, Stephan, 87484 Nesselwang (DE)
(74) Vertreter: Andres, Angelika Maria
(86) Internationale Anmeldenummer: PCT/EP2011/068369
(87) Internationale Veröffentlichungsnummer: WO 2012/062552

(56) Entgegenhaltungen:
- WO-A2-2004/051860
- WO-A2-2004/095704
- DE-T2- 69 428 869
- US-A1- 2008 180 293

## Beschreibung

Die vorliegende Erfindung betrifft einen Delta-Sigma-Digital/Analog-Wandler (Delta-Sigma-D/A-Wandler), durch den ein digitalwertiges Eingangssignal in ein binäres, entsprechend einem Takt zeitdiskretes Ausgangssignal wandelbar ist. Dabei ist durch einen, über mehrere Takte gebildeten Mittelwert des Ausgangssignals der Wert des Eingangssignals analog darstellbar.

Delta-Sigma-D/A-Wandler weisen mindestens einen Delta-Sigma-Modulator erster oder höherer Ordnung auf. Delta-Sigma-Modulatoren sind grundsätzlich aus dem Stand der Technik bekannt. Durch Delta-Sigma-Modulatoren wird ein (digitalwertiges oder analoges) Eingangssignal bearbeitet und in ein binäres, entsprechend einem Takt zeitdiskretes Ausgangssignal gewandelt, wobei in die Bearbeitung des Eingangssignals jeweils das ausgegebene Ausgangssignal mit eingeht. Die Taktrate, mit der ein Delta-Sigma-Modulator betrieben wird und mit der das Ausgangssignal ausgegeben wird, ist in der Regel deutlich höher als die Datenrate des Eingangssignals und auch höher als bei vielen anderen D/A-Wandlern (Prinzip der Überabtastung). Das Ausgangssignal kann bei jedem Takt genau einen von zwei Werten, die als "1" und "0" bezeichnet werden, annehmen. Dementsprechend wird das Ausgangssignal durch einen Stream (deutsch: Strom) von "1"en und "0"en gebildet, wobei die Datenrate, mit der diese Werte ausgegeben werden, der Taktrate des Delta-Sigma-Modulators entspricht. Das Ausgangssignal eines Delta-Sigma-Modulators wird häufig auch als Bitstream bezeichnet. Der Mittelwert des Ausgangssignals des Delta-Sigma-Modulators entspricht dem Wert des Eingangssignals.

Delta-Sigma-Modulatoren werden häufig in hochauflösenden D/A-Wandlem eingesetzt, da in diesen aufgrund des Prinzips der Überabtastung ein hoher Rauschabstand erzielt werden kann. Ferner sind Delta-Sigma-Modulatoren relativ einfach in einem ASIC (engl.: application specific integrated circuit; deutsch: Anwendungsspezifische Integrierte Schaltung), einem CPLD (engl.: complex programmable logic device; deutsch: Komplexes Programmierbares Logikgerät), und/oder in einem FPGA (engl.: Field Programmable Gate Array; deutsch: frei programmierbare logische Anordnung) implementierbar. Bei einem Einsatz in einem D/A-Wandler ist das Eingangssignal des Delta-Sigma-Modulators digitalwertig. Das Ausgangssignal des Delta-Sigma-Modulators, das in der Regel durch einen Bitstream gebildet wird, wird durch einen analogen Tiefpassfilter gefiltert, so dass ein analoges Signal erhalten wird, dessen Wert dem digitalen Eingangswert des Eingangssignals entspricht.

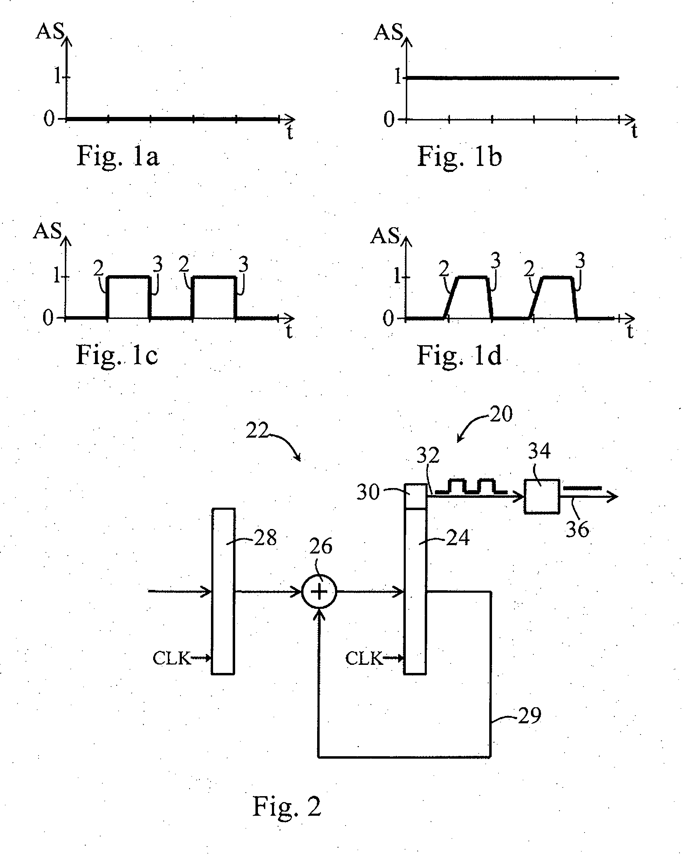

Je nach dem darzustellenden Eingangswert des (digitalwertigen) Eingangssignals weist in einem Delta-Sigma-D/A-Wandler das Ausgangssignal des Delta-Sigma-Modulators ein unterschiedliches Verhältnis von "1"en und "0"en auf. Dadurch hängt auch die Frequenz, mit der ein Wechsel zwischen "1"en und "0"en erfolgt, von dem darzustellenden Eingangswert ab. Dies wird nachfolgend unter Bezugnahme auf die Fig. 1a - 1c erläutert, in denen jeweils das Ausgangssignal AS eines Delta-Sigma-Modulators über der Zeit t aufgetragen ist. Entlang der Zeitachse sind dabei jeweils die Taktzyklen angedeutet. Beispielsweise wird in dem Ausgangssignal des Delta-Sigma-Modulators der minimale, darstellbare Eingangswert durch eine Serie von "0"en dargestellt, wie es in Fig. 1a gezeigt ist. Der maximale, darstellbare Eingangswert wird durch eine Serie von "1"en dargestellt, wie es in Fig. 1b gezeigt ist. In beiden Fällen weist das Ausgangssignal eine Frequenz von 0 Hz (minimale Frequenz) auf. Die maximale Frequenz in dem Ausgangssignal wird erreicht, wenn sich in dem Ausgangssignal des Delta-Sigma-Modulators die "0" und die "1" bei jedem Takt abwechseln, wie es in Fig. 1c dargestellt ist. Je nach darzustellendem Eingangswert variiert folglich die Frequenz des Ausgangssignals in diesem relativ großen Frequenzbereich.

Analoge Tiefpassfilter sind in der Regel für einen relativ engen Frequenzbereich ausgelegt, in dem sie dann eine sehr gute Filtercharakteristik erzielen. Je größer der Abstand der tatsächlichen Frequenz von diesem optimalen Frequenzbereich ist, desto schlechterwird in der Regel die Filterchärakteristik. Dadurch, dass die Frequenz des Ausgangssignals des Delta-Sigma-Modulators über einen weiten Bereich variieren kann, müssen bisher in Delta-Sigma-D/A-Wandlern relativ aufwändige, analoge Tiefpassfilter zur Filterung des Ausgangssignals eingesetzt werden. Ein weiteres Problem besteht darin, dass in dem Ausgangssignal die Flanken (ansteigende und absteigende Flanken) in der Regel nicht so ideal rechtwinklig verlaufen, wie dies in Fig. 1c dargestellt ist. Vielmehr tritt in dem Bereich der Flanken (vgl. ansteigende Flanken 2 und abfallende Flanken 3 in den Fig. 1c und 1d) häufig eine Verzerrung auf, was beispielhaft in Fig. 1d dargestellt ist. Aufgrund der Verzerrung weicht der Signalverlauf im Bereich der Flanken 2, 3 von einem idealen Rechtecksignal ab. Häufig wird das Ausgangssignal noch über eine galvanische Trennung übertragen, bevor es dem analogen Tiefpassfilter zugeführt. Dies führt in der Regel noch zu einer zusätzlichen Verzerrung der Flanken 2, 3. Die Verzerrung der Flanken 2, 3 führt zu einem Fehler. Beispielsweise erfolgt eine analoge Tiefpassfilterung in der Regel derart, dass die Fläche unter dem zu filternden Signal über die Zeit gemittelt wird. Aufgrund der Verzerrung tritt bei dieser Mittelung bzw. Tiefpassfilterung eine Abweichung gegenüber einem idealen, rechteckförmigen Signalverlauf auf. Zusätzlich problematisch ist, dass dieser Fehler mit der Anzahl der Flanken korreliert. Indem die Frequenz des Ausgangssignals des Delta-Sigma-Modulators und damit die Anzahl der Flanken (pro Zeit) über einen großen Bereich variieren, kann der durch die Verzerrung entstehende Fehler nicht einfach durch einen konstanten Offset (deutsch: Versatz) korrigiert werden.

Derartige Delta-Sigma-D/A-Wandler sind z.B. bekannt aus US 2008/0180293 A1 and WO 2004/051860 A2.

Diese Problematik besteht insbesondere in den Fällen, in denen ein digitalwertiger Messwert oder ein digitalwertiger Stellwert in eine analoge Spannungs- oder Stromgröße zu wandeln ist. Insbesondere bei dieser Anwendung wird eine möglichst exakte Wandlung mit hoher Linearität angestrebt.

Demgemäß besteht die Aufgabe der vorliegenden Erfindung darin, einen Delta-Sigma-D/A-Wandler bereitzustellen, der über den darzustellenden Eingangswertebereich des Eingangssignals eine möglichst exakte Digital-Analog-Wandlung ermöglicht, ohne dass aufwändige (analoge) Filter eingesetzt und/oder eine aufwändige Fehlerkorrektur durchgeführt werden müssen.

Die Aufgabe wird durch einen Delta-Sigma-D/A-Wandler gemäß Anspruch 1 gelöst. Vorteilhafte Weiterbildungen der Erfindung sind in den Unteransprüchen angegeben.

Gemäß der vorliegenden Erfindung wird ein Delta-Sigma-D/A-Wandler, durch den ein digitalwertiges Eingangssignal in ein binäres, entsprechend einem Takt zeitdiskretes Ausgangssignal wandelbar ist, bereitgestellt. Dabei ist durch einen über mehrere Takte gebildeten Mittelwert des Ausgangssignals der Wert (nachfolgend als "Eingangswert" bezeichnet) des Eingangssignals analog darstellbar. Der Delta-Sigma-D/A-Wandler ist derart ausgebildet, dass er im Einsatz das Ausgangssignal durch Aneinanderreihen von Signalmustern eines Satzes von Signalmustern bereitstellt, wobei die Signalmuster des Satzes jeweils binär sind, entsprechend dem Takt zeitdiskret sind und sich über eine Signalmuster-Taktlänge von mehreren Takten erstrecken. Mindestens zwei Signalmuster des Satzes weisen voneinander unterschiedliche Signalmuster-Mittelwerte, die über die jeweilige Signalmuster-Taktlänge gebildet werden, auf und alle Signalmuster des Satzes weisen jeweils im Wesentlichen die gleiche Anzahl, insbesondere genau die gleiche Anzahl, von Flanken auf.

Durch den erfindungsgemäßen Delta-Sigma-D/A-Wandler werden weiterhin die Vorteile der Delta-Sigma-Wandlung, die unter anderem in dem hohen Rauschabstand und der einfachen Implementierbarkeit liegen, genutzt. Insbesondere ist das bereitgestellte Ausgangssignal weiterhin derart ausgebildet, dass dessen Mittelwert dem Wert (bzw. Eingangswert) des digitalwertigen Eingangssignals entspricht. Indem das Ausgangssignal aus Signalmustern zusammengesetzt wird, die jeweils im Wesentlichen die gleiche Anzahl von Flanken aufweisen, wird der Frequenzbereich des Ausgangssignals erheblich reduziert. Insbesondere weist das Ausgangssignal unabhängig davon, welcher Eingangswert dargestellt wird, im Wesentlichen eine konstante Frequenz und im Wesentlichen eine konstante Anzahl von Flanken über die Zeit auf. Auf diese Weise ist eine weniger aufwändige Tiefpassfilterung des Ausgangssignals zur Bereitstellung des analogen Signals erforderlich und es kann gleichzeitig eine ausgezeichnete Filtercharakteristik erzielt werden. Ferner wird die Korrektur eines Fehlers, der durch die Verzerrung der Flanken hervorgerufen wird, erleichtert, da der Fehler unabhängig von dem dargestellten Eingangswert im Wesentlichen konstant ist. Die Fehlerkorrektur kann folglich einfach durch einen Offset (deutsch: Versatz) erfolgen. Weiterhin ist in Bezug auf einige Anwendungen, wie beispielsweise bei der Verwendung des Delta-Sigma-D/A-Wandlers zur Einstellung eines Stromwertes (z.B. gemäß dem 4-20 mA Standard), um damit einen Messwert oder einen Stellwert darzustellen, vorteilhaft, dass gemäß der vorliegenden Erfindung das Ausgangssignal nicht vollständig auf einen Ausgangswert von null abfallen kann.

Als Delta-Sigma-D/A-Wandler wird ein D/A-Wandler verstanden, in dem eine Delta-Sigma-Modulation durchführbar ist. Insbesondere weist solch ein Delta-Sigma-D/A-Wandler mindestens einen Delta-Sigma-Modulator (erster oder höherer Ordnung) auf. Der Delta-Sigma-Modulator selbst kann dabei auf unterschiedliche Weise ausgebildet sein.

Unter einem "binären" Ausgangssignal wird ein Ausgangssignal verstanden, das wertdiskret ist und das zu einem Zeitpunkt immer nur genau einen von zwei möglichen Binärwerten annehmen kann. Die Binärwerte werden vorliegend als "1" und als "0" bezeichnet, wobei grundsätzlich auch alternative Bezeichnungen wie "High" (deutsch: Hoch) und "Low" (deutsch: Niedrig) möglich sind: Die Binärwerte werden in dem Ausgangssignal beispielsweise durch zwei verschiedene Spannungswerte dargestellt, wobei alternativ auch zwei verschiedene Stromwerte, etc. möglich sind. Unter "entsprechend einem Takt zeitdiskret" wird verstanden, dass das Ausgangssignal über eine Taktlänge des Taktes hinweg immer einen konstanten Wert (der vorliegend einem der beiden Binärwerte entspricht) annimmt. Die oberhalb erläuterten Eigenschaften des "binären, entsprechend einem Takt zeitdiskreten Ausgangssignals" entsprechen einem idealen Signalverlauf. Es werden aber auch Signalverläufe umfasst, die von diesem idealen Signalverlauf aufgrund von Verzerrungen, Fehlern, etc. etwas abweichen. Unter "analog darstellbar" wird verstanden, dass der Mittelwert des Ausgangssignals über eine vorbestimmte Beziehung mit dem (digitalen) Eingangswert des Eingangssignals korreliert ist. Dabei muss der Mittelwert des Ausgangssignals nicht zwingend genau dem Eingangswert des Eingangssignals entsprechen. Beispielsweise kann er auch proportional zu diesem und/oder um einen Versatz zu diesem verschoben sein.

Da das Ausgangssignal durch Aneinanderreihen der Signalmuster gebildet wird, weisen die Signalmuster des Satzes von Signalmustern jeweils die gleichen Binärwerte und den gleichen Takt wie das oberhalb erläuterte Ausgangssignal auf. Die Signalmuster-Taktlänge der Signalmuster beträgt vorzugsweise mindestens drei Takte. Mit "Anzahl von Flanken" wird auf die Gesamtanzahl von Flanken des betreffenden Signalmusters Bezug genommen, unabhängig davon, ob es sich um ansteigende oder abfallende Flanken handelt. Welche Anzahl von Flanken noch als "im Wesentlichen gleich" angesehen wird, hängt von der Signalmuster-Taktlänge der jeweiligen Signalmuster und dem noch als tolerierbar angesehenen Fehler ab. Das beste Ergebnis wird dann erzielt, wenn sämtliche Signalmuster des Satzes (vorzugsweise bei jeweils gleicher Signalmuster-Taktlänge) exakt die gleiche Anzahl von Flanken aufweisen. Vorzugsweise sind dabei genau gleich viele ansteigende wie abfallende Flanken innerhalb von einem Signalmuster vorgesehen. Bei bestimmten Anwendungen und insbesondere bei langen Signalmuster-Taktlängen können aber auch geringfügige Abweichungen in der Anzahl der Flanken noch zu einem guten Ergebnis führen.

Der Signalmuster-Mittelwert bestimmt dabei die Gewichtung, die das jeweilige Signalmuster in dem Ausgangssignal hat. Es müssen folglich die verschiedenen Signalmuster so aneinandergereiht werden, dass durch den über die Zeit gebildeten Mittelwert des erhaltenen Ausgangssignals der Wert (bzw. Eingangswert) des Eingangssignals analog darstellbar ist. Der Satz von Signalmustern kann aus genau zwei Signalmustern mit unterschiedlichen Signalmuster-Mittelwerten oder auch aus mehr als zwei Signalmustern mit jeweils unterschiedlichen Signalmuster-Mittelwerten gebildet werden. In letzterem Fall kann der durch das Ausgangssignal darzustellende Ausgangswertebereich in mehrere Teilbereiche unterteilt werden. Dabei können Ausgangswerte innerhalb eines Teilbereichs (die nicht genau einem Signalmuster-Mittelwert entsprechen) jeweils durch Modulation von zwei Signalmustern, bei denen das eine Signalmuster einen höheren und das andere Signalmuster einen niedrigeren Signalmuster-Mittelwert als der darzustellende Ausgangswert aufweist, dargestellt werden. Insbesondere kann die Darstellung durch Modulation der zwei Signalmuster erfolgen, deren Signalmuster-Mittelwerte am nächsten an dem darzustellenden Ausgangswert liegen.

Gemäß der vorliegenden Erfindung kann auch vorgesehen sein, dass Signalmuster eine unterschiedliche Anzahl von ansteigenden und abfallenden Flanken aufweisen. Insbesondere dann, wenn der durch eine Verzerrung verursachte Fehler bei einer ansteigenden Flanke im Wesentlichen gleich wie bei einer abfallenden Flanke ist, können gute Ergebnisse erzielt werden. Das Aneinanderreihen von Signalmustern, die innerhalb eines Signalmusters eine unterschiedliche Anzahl von ansteigenden und abfallenden Flanken aufweisen, kann jedoch einen zusätzlichen Aufwand erfordern, da jeweils der Anfang eines nachfolgenden Signalmusters dem Ende des jeweils vorangehenden Signalmusters entsprechen muss. Gemäß einer Weiterbildung weisen alle Signalmuster des Satzes jeweils die gleiche Anzahl von ansteigenden Flanken und jeweils diese gleiche Anzahl von abfallenden Flanken auf. Dies bedeutet, dass jedes Signalmuster bei dem Binärwert, bei dem es anfängt, auch endet. Auf diese Weise wird der Aufwand für die Auswahl der aneinanderzureihenden Signalmuster reduziert, da diese grundsätzlich in beliebiger Kombination aneinandergereiht werden können. Die Anzahl der ansteigenden und abfallenden Flanken kann dabei pro Signalmuster jeweils nur eins sein, sie kann aber auch höher als eins sein.

Gemäß einer Weiterbildung weisen alle Signalmuster des Satzes jeweils die gleiche Signalmuster-Taktlänge auf. Auf diese Weise kann der Delta-Sigma-Modulator mit einer konstanten Modulatortaktfrequenz betrieben werden. Die Modulatortaktfrequenz entspricht dabei insbesondere der Rate, mit der die einzelnen Signalmuster in dem Ausgangssignal ausgegeben werden. Gemäß einer Weiterbildung weisen alle Signalmuster des Satzes jeweils genau eine ansteigende und genau eine abfallende Flanke auf. Dadurch können auf besonders einfache Weise viele (wobei die maximale, mögliche Anzahl von der Signalmuster-Taktlänge abhängt) Signalmuster mit jeweils verschiedenen Signalmuster-Mittelwerten bereitgestellt werden.

Teilweise bestehen bei vorgegebener Signalmuster-Taktlänge und bei einem bestimmten Signalmuster-Mittelwert unterschiedliche Möglichkeiten der tatsächlichen Gestaltung des Signalmusters. Dies ist auch bei der oberhalb beschriebenen Weiterbildung, bei der jedes Signalmuster genau eine ansteigende und genau eine abfallende Flanke aufweist, zumindest bei einigen Signalmuster-Mittelwerten möglich. Die Vorsehung unterschiedlicher Signalmuster mit gleichem Signalmuster-Mittelwert erfordert jedoch einen zusätzlichen Aufwand bei der Verwaltung sowie bei der Auswahl der Signalmuster. Gemäß einer Weiterbildung ist dementsprechend vorgesehen, dass alle Signalmuster des Satzes jeweils unterschiedliche Signalmuster-Mittelwerte aufweisen.

Gemäß einer Weiterbildung weisen alle Signalmuster des Satzes eine Signalmuster-Taktlänge von m Takten auf, der Satz weist m-1 verschiedene Signalmuster mit jeweils unterschiedlichen Signalmuster-Mittelwerten auf, das Signalmuster mit dem niedrigsten Signalmuster-Mittelwert nimmt genau einen Takt lang den hohen der zwei zur Verfügung stehenden Binärwerte und die verbleibenden m-1 Takte den niedrigen Binärwert an, und jedes Signalmuster des Satzes nimmt gegenüber dem Signalmuster mit dem nächst niedrigeren Signalmuster-Mittelwert um genau einen Takt länger den hohen Binärwert an. Gemäß dieser Weiterbildung kann auf einfache Weise bei einer vorbestimmten Signalmuster-Taktlänge eine möglichst hohe Anzahl von Signalmustern mit jeweils unterschiedlichem Signalmuster-Mittelwert bereitgestellt werden. Alternativ kann aber auch ein Satz von Signalmustern bereitgestellt werden, bei dem jedes Signalmuster gegenüber dem Signalmuster mit dem nächst niedrigeren Signalmuster-Mittelwert um genau 2, 3, 4, ... oder n Takte länger den hohen Binärwert einnimmt, so dass ein größerer Abstand zwischen den Signalmuster-Mittelwerten der einzelnen Signalmuster realisiert wird.

Bei dem Delta-Sigma-D/A-Wandler ist, da ein digitalwertiges Eingangssignal verarbeitet wird, die Schaltung zur Erzeugung des Ausgangssignals vorzugsweise digital ausgebildet. Gemäß einer Weiterbildung weist der Delta-Sigma-D/A-Wandler einen digitalen Delta-Sigma-Modulator, durch den zumindest ein Teil des digitalwertigen Eingangssignals modulierbar ist, auf. Insbesondere kann vorgesehen sein, dass das gesamte, digitalwertige Eingangssignal durch den Delta-Sigma-Modulator moduliert wird. Alternativ kann aber auch, wie unterhalb in Bezug auf eine Weiterbildung erläutert wird, ein Teil des digitalwertigen Eingangssignals abgezweigt werden und nur der verbleibende Teil des digitalwertigen Eingangssignals dem Delta-Sigma-Modulator zugeführt werden. Gemäß einer Weiterbildung wird der digitale Delta-Sigma-Modulator durch einen digitalen Delta-Sigma-Modulator erster Ordnung gebildet.

Gemäß einer Weiterbildung ist der Delta-Sigma-D/A-Wandler derart ausgebildet, dass von dem digitalwertigen Eingangssignal eine vorbestimmte Stellenanzahl der höchstwertigen Bitstellen abzweigbar ist und die verbleibenden Bitstellen dem digitalen Delta-Sigma-Modulator zur Erzeugung eines binären, entsprechend einem Modulatortakt zeitdiskreten Modulator-Ausgangssignals zuführbar sind. Dabei wird/werden mindestens eine, vorzugsweise auch mehrere Bitstellen abgezweigt, wobei die Anzahl der abgezweigten Bitstellen während des Betriebs des Delta-Sigma-D/A-Wandlers in der Regel konstant bleibt. Der Modulatortakt weicht dabei insbesondere von dem oberhalb, in Bezug auf die Signalmuster erläuterten Takt ab. Insbesondere entspricht die Modulatortaktfrequenz nur einem Bruchteil der Taktfrequenz. Insbesondere entspricht die Modulatortaktfrequenz einer Signalmuster-taktfrequenz, mit der die einzelnen Signalmuster in dem Ausgangssignal ausgegeben werden.

Gemäß einer Weiterbildung ist eine Zuordnung definiert, durch die jedem Signalmuster des Satzes jeweils eine, dessen Signalmuster-Mittelwert entsprechende Belegung der abzweigbaren, höchstwertigen Bitstelle(n) des digitalwertigen Eingangssignals zugeordnet wird. Ferner weist der Delta-Sigma-D/A-Wandler einen Signalmuster-Generator auf, durch den in Abhängigkeit von der jeweiligen Belegung der abgezweigten, höchstwertigen Bitstelle(n) entsprechend der Zuordnung das zugehörige Signalmuster bestimmbar ist, und dieses bestimmte Signalmuster ist durch den Signal-muster-Generator als untere Modulationsgröße zur Bildung des Ausgangssignals ausgebbar. Die Zuordnung ist dabei insbesondere eindeutig und so definiert, dass der mögliche, darstellbare Eingangswertebereich des digitalwertigen Eingangssignals möglichst gleichmäßig durch die verfügbaren Signalmuster-Mittelwerte des Satzes von Signalmustern unterteilt wird. Da durch die abgezweigte(n), höchstwertige(n) Bitstelle(n) bereits die Größenordnung des Eingangswertes bestimmt wird, kann die Zuordnung einfach anhand dieser abgezweigten, höchstwertigen Bitstellen erfolgen. Insbesondere kann vorgesehen sein, dass das zu einer bestimmten Belegung der abzweigbaren, höchstwertigen Bitstelle(n) zugehörige Signalmuster einen Signalmuster-Mittelvvert aufweist, der exakt dem Wert der bestimmten Belegung, wobei für die verbleibenden Bitstellen des Eingangssignals jeweils eine Belegung mit "0" angenommen wird, entspricht. Alternativ kann aber auch vorgesehen sein, dass der Signalmuster-Mittelwert porportional zu diesem Eingangswert (vorzugsweise mit einem für alle Signalmuster des Satzes einheitlichen Proportionalitätsfaktor) und/oder um einen Offset (deutsch: Versatz) zu diesem verschoben ist. Das (bekannte) Verhältnis zwischen der jeweiligen Belegung der abzweigbaren, höchstwertigen Bitstellen des Eingangssignals zu dem zugehörigen Signalmuster-Mittelwert, durch das auch das Verhältnis eines Eingangswertes des digitalwertigen Eingangssignals zu einem, über mehrere Takte gebildeten Mittelwert des Ausgangssignals bestimmt wird, muss lediglich bei der Auswertung und/oder weiteren Bearbeitung des von dem Delta-Sigma-D/A-Wandler bereitgestellten Ausgangssignals berücksichtigt werden. Gegebenenfalls kann auch vorgesehen sein, dass das digitalwertige Eingangssignal zunächst bearbeitet, insbesondere um einen Offset (deutsch: Versatz) verschoben und/oder mit einem Faktor skaliert wird, um es optimal an den von den Signalmustern des Satzes abgedeckten Bereich anzupassen. Solche Signalverarbeitungen des Eingangssignals (d.h. vor Zuführung desselben zu dem Delta-Sigma-D/A.; Wandler) und/oder des Ausgangssignals (d.h. nach Bereitstellung desselben durch den Delta-Sigma-D/A-Wandler) sind einfach möglich und können bei der weiteren Bearbeitung des jeweiligen Signals (aufgrund der bekannten, vorgenommenen Änderungen) entsprechend berücksichtigt werden.

Die Bestimmung des jeweils zugehörigen Signalmusters in Abhängigkeit von der Belegung der abgezweigten, höchstwertigen Bitstelle(n) kann in dem Signalmuster-Generator insbesondere mit Hilfe einer Lookup-Tabelle (deutsch: Nachschlag-Tabelle) durchgeführt werden. In einer Lookup-Tabelle können auf einfache Weise entsprechend der Zuordnung zu jeder möglichen Belegung der abzweigbaren, höchstwertigen Bitstelle(n) das jeweils entsprechende Signalmuster gespeichert werden. Dadurch kann die Bestimmung in dem Signalmuster-Generator schnell und einfach durchgeführt werden. Gemäß einer Weiterbildung ist das Signalmuster mit dem nächst höheren Signalmuster-Mittelwert im Vergleich zu dem Signalmuster-Mittelwert des als untere Modulationsgröße bestimmten Signalmusters durch den Signalmuster-Generator als obere Modulationsgröße zur Bildung des Ausgangssignals ausgebbar. Eine solche zweite Modulationsgröße ist nur dann nicht erforderlich, wenn der Eingangswert des Eingangssignals genau durch den Signalmuster-Mittelwert des als untere Modulationsgröße bestimmten Signalmusters darstellbar ist. Ist der Eingangswert dagegen etwas größer, was insbesondere dann der Fall ist, wenn die nach dem Abzweigen verbleibenden Bitstellen des Eingangssignals eine von durchgehend "0" abweichende Belegung aufweisen, so ist auch die obere Modulationsgröße zur Darstellung des Eingangssignals erforderlich.

Das Verhältnis, gemäß welchem die untere Modulatiönsgröße und die obere Modulationsgröße in dem Ausgangssignal auftreten, wird insbesondere durch die nach dem Abzweigen verbleibenden Bitstellen bestimmt. Gemäß einer Weiterbildung ist vorgesehen, dass das ModulatorAusgangssignal des digitalen Delta-Sigma-Modulators (dem die verbleibenden Bitstellen zugeführt wurden) dem Signalmuster-Generator zuführbar ist und dass die Modulation zwischen der unteren Modulationsgröße und der oberen Modulationsgröße (durch den Signalmuster-Generator) in Abhängigkeit von dem Modulator-Ausgangssignal durchgeführt wird. Gemäß einer Weiterbildung entspricht ein Modulatortakt, mit dem der digitale Delta-Sigma-Modulator betrieben und das Modulator-Ausgangssignal ausgegeben wird, einem Signalmustertakt, mit dem einzelne Signalmuster durch den Signalmuster-Generator ausgegeben werden. Der Signalmustertakt wiederum wird durch die Zeitdauer eines Signalmusters, die sich aus der Zeitdauer eines Taktes und der Signalmuster-Taktlänge ergibt, bestimmt.

Gemäß einer Weiterbildung weist der Delta-Sigma-D/A-Wandler einen analogen Tiefpass-Filter, durch den eine Filterung des Ausgangssignals durchführbar ist, auf. Durch den Tiefpass-Filter wird dann ein analoges Signal, dessen Wert dem digitalwertigen Eingangssignal entspricht, bereitgestellt. Der Tiefpass-Filter kann beispielsweise durch ein RG-Glied (Widerstands-Kondensator-Glied) gebildetwerden. Gemäß einer Weiterbildung ist der Delta-Sigma-D/A-Wandler in einem ASIC (engl.: application specific integrated circuit; deutsch: Anwendungsspezifische Integrierte Schaltung), einem CPLD (engl.: complex programmable logic device; deutsch: Komplexes Programmierbares Logikgerät), oder in einem FPGA (engl.: Field Programmable Gate Array; deutsch: frei programmierbare logische Anordnung) ausgebildet.

Es kann der Fall auftreten, dass der von den Signalmustern des Satzes abgedeckte Ausgangswertebereich nicht ausreicht, um den möglichen Eingangswertebereich des digitalen Eingangssignals abzudecken. Gemäß einer Weiterbildung ist der Delta-Sigma-D/A-Wändler derart ausgebildet, dass für den Fall, dass ein Eingangswert unterhalb des von den Signalmustern abgedeckten Eingangswertebereichs liegt, durch den Signalmuster-Generator das Signalmuster mit dem niedrigsten Signalmuster-Mittelwert des Satzes ausgebbar ist. Gemäß einer Weiterbildung ist der Delta-Sigma-D/A-Wandler derart ausgebildet, dass für den Fall, dass das digitalwertige Eingangssignal oberhalb des von den Signalmustern abgedeckten Eingangswertebereichs liegt, durch den Signalmuster-Generator das Signalmuster mit dem höchsten Signalmuster-Mittelwert des Satzes ausgebbar ist. In beiden Fällen ist bevorzugt, dass durch den Delta-Sigma-Modulator keine Modulation ausgeführt wird und das betreffende Signalmuster so viele Iterationen ausgegeben wird, bis der Eingangswert wieder innerhalb des abgedeckten Eingangswertebereichs liegt.

Wie bereits in der Einleitung erläutert wurde, besteht insbesondere dann ein Bedarf an einer exakten Wandlung mit hoher Linearität, wenn ein digitalwertiger Messwert oder ein digitalwertiger Stellwert in eine analoge Spannungs- oder Stromgröße zu wandeln ist. Dies ist beispielsweise dann der Fall, wenn ein, in einem Messgerät erfasster Messwert als Digitalwert vorliegt und als analoge Stromgröße über einen analogen Stromausgang des Messgerätes an einen entsprechenden Empfänger (beispielsweise an ein übergeordnetes Steuergerät oder an einen Messumformer) zu übermitteln ist. Weiterhin ist dies dann der Fall, wenn ein, in einem Steuergerät bestimmter Stellwert als Digitalwert vorliegt und als analoge Stromgröße über einen analogen Stromausgang des Steuergerätes an einen entsprechenden Empfänger, wie beispielsweise an ein Stellgerät bzw. einen Aktor (z.B. Ventil, Pumpe, etc.), zu übermitteln ist. Dementsprechend betrifft die vorliegende Erfindung ferner die Verwendung eines erfindungsgemäßen Delta-Sigma-D/A-Wandlers, der zusätzlich auch gemäß einer oder mehrerer der oberhalb erläuterten Weiterbildungen und Varianten ausgebildet sein kann, in einem Gerät mit einem analogen Strom- oder Spannungsausgang zur Umwandlung eines, von dem Gerät bestimmten, digitalwertigen Messwertes oder zur Umwandlung eines, von dem Gerät bestimmten, digitalwertigen Stellwertes in ein analoges Strom- oder Spannungssignal, das über den analogen Strom- oder Spannungsausgang ausgebbar ist. Dabei können an der Umwandlung auch noch weitere (elektronische) Bauteile beteiligt sein, die insbesondere ein von dem Delta-Sigma-D/A-Wandler ausgegebenes, analoges Signal noch weiter bearbeiten, bevor es über den analogen Strom- oder Spannungsausgang ausgegeben wird. Beispielsweise kann der Delta-Sigma-D/A-Wandler eine analoge Spannung ausgeben und eine Stromregelschaltung und ein entsprechendes Stellglied wandeln diese in einen entsprechenden, über den analogen Stromausgang des Gerätes auszugebenden Stromwert um. Insbesondere handelt es sich bei dem Gerät um ein Messgerät, durch das ein dem Messwert entsprechender Stromwert (z.B. gemäß dem 4-20 mA Standard) über einen analogen Stromausgang des Messgerätes auszugeben ist. Dabei kann es sich insbesondere um ein 2-Leiter-Messgerät handeln, das über eine 2-Leiter-Stromschleife, die an dem analogen Stromausgang angeschlossen wird, gleichzeitig mit elektrischer Leistung versorgbar ist.

Das Gerät kann dabei neben dem analogen Strom- oder Spannungsausgang auch noch weitere Eingänge und/oder Ausgänge zum Empfangen und/oder Senden von Signalen aufweisen. Das Gerät kann insbesondere, wie nachfolgend erläutert wird, durch ein Messgerät oder ein Steuergerät, gebildet werden. Weiterhin kann das Gerät auch durch ein Stellgerät (bzw. einen Aktor), das beispielsweise ein Rückkopplungssignal (insbesondere entsprechend einem von einem Steuergerät erhaltenen Stellwert) an dem analogen Stromausgang einstellt, gebildet werden. Ferner kann das Gerät durch einen Messumformer gebildet werden, der beispielsweise einen Messwert von einem Gerät als Eingangssignal erhält, diesen bearbeitet und über den analogen Stromausgang wieder einen (bearbeiteten) Messwert ausgibt. In die in dem Messumformer durchgeführte Bearbeitung können gegebenenfalls auch noch Messwerte und/oder Stellwerte von weiteren Geräten eingehen.

In der Industrie ist weit verbreitet, Messwerte und Stellwerte über eine elektrische Stromschleife zu übermitteln. Hierbei entspricht ein in der Stromschleife eingestellter elektrischer Strom dem jeweiligen Wert des zu übermittelnden Messwertes beziehungsweise Stellwertes. Weit verbreitet ist der 4-20 mA Standard (mA: Milliampere), bei dem entsprechend dem jeweils zu übermittelnden Messwert bzw. Stellwert Stromwerte im Bereich von einem unteren Strom-Grenzwert von 4 mA bis zu einem oberen Strom-Grenzwert von 20 mA eingestellt werden. Dabei können aber auch andere Grenzwerte für den Bereich gewählt werden, wie beispielsweise ein unterer Strom-Grenzwert von 0 mA und ein oberer Strom-Grenzwert von 20 mA. Gemäß einer Weiterbildung ist dementsprechend vorgesehen, dass die Umwandlung des Messwertes oder des Stellwertes (in dem Gerät) in ein Stromsignal, insbesondere in ein Stromsignal gemäß dem 4-20 mA Standard, erfolgt. Das Stromsignal kann dann über einen entsprechenden, analogen Stromausgang des Gerätes ausgegeben werden.

Die vorliegende Erfindung betrifft ferner ein Messgerät mit einem analogen Strom- oder Spannungsausgang, das einen erfindungsgemäßen Delta-Sigma-D/A-Wandler, der zusätzlich auch gemäß einer oder mehrerer der oberhalb erläuterten Weiterbildungen und Varianten ausgebildet sein kann, aufweist. Dabei ist dem Delta-Sigma-D/A-Wandler ein in dem Messgerät bestimmter, digitalwertiger Messwert als digitalwertiges Eingangssignal zuführbar und das Ausgangssignal des Delta-Sigma-D/A-Wandlers ist zur Erzeugung eines, dem digitalwertigen Messwert entsprechenden, analogen Strom- bzw. Spannungssignals an dem analogen Strom- bzw. Spannungsausgang ausgebbar. Das (anschließend noch gefilterte) Ausgangssignal des Delta-Sigma-D/A-Wandlers wird dabei insbesondere noch weiter bearbeitet, bevor es über den analogen Strom- oder Spannungsausgang ausgegeben wird. Beispielsweise kann nach der Filterung des Ausgangssignals des Delta-Sigma-D/A-Wandlers eine analoge Spannung erhalten werden, die durch eine Stromregelschaltung und ein Stellglied dann in einen, über den analogen Stromausgang auszugebenden Stromwert umgewandelt wird.

Die vorliegende Erfindung betrifft ferner ein Steuergerät mit einem analogen Strom- oder Spannungsausgang, das einen erfindungsgemäßen Delta-Sigma-D/A-Wandler, der zusätzlich auch gemäß einer oder mehrerer der oberhalb erläuterten Weiterbildungen und Varianten ausgebildet sein kann, aufweist. Dabei ist dem Delta-Sigma-D/A-Wandler ein, in dem Steuergerät bestimmter, digitalwertiger Stellwert als digitalwertiges Eingangssignal zuführbar und das Ausgangssignal des Delta-Sigma-D/A-Wandlers ist zur Erzeugung eines, dem digitalwertigen Stellwert entsprechenden, analogen Strom- bzw. Spannungssignals an dem analogen Strom- bzw. Spannungsausgang ausgebbar. Wie dies oberhalb in Bezug auf das Messgerät erläutert wurde, kann das (anschließen noch gefilterte) Ausgangssignal des Delta-Sigma-D/A-Wandlers auch noch weiter bearbeitet werden, bevor es über den analogen Strom-oder Spannungsausgang ausgegeben wird.

Die vorliegende Erfindung betrifft ferner ein Verfahren zum Betreiben eines Delta-Sigma-D/A-Wandlers, durch den ein digitalwertiges Eingangssignal in ein binäres Ausgangssignal, das entsprechend einem Takt zeitdiskret ist, wandelbar ist, wobei durch einen über mehrere Takte gebildeten Mittelwert des Ausgangssignals der Wert (bzw. Eingangswert) des Eingangssignals analog darstellbar ist, gekennzeichnet durch nachfolgenden Schritt:
Bereitstellen des Ausgangssignals durch den Delta-Sigma-D/A-Wandler durch Aneinanderreihen von Signalmustern eines Satzes von Signalmustern, wobei die Signalmuster des Satzes jeweils binär sind, entsprechend dem Takt zeitdiskret sind und sich über eine Signalmuster-Taktlänge von mehreren Takten erstrecken, wobei mindestens zwei Signalmuster des Satzes voneinander unterschiedliche Signalmuster-Mittelwerte, die über die jeweilige Signalmuster-Taktlänge gebildet werden, aufweisen und wobei alle Signalmuster des Satzes jeweils im Wesentlichen die gleiche Anzahl von Flanken, insbesondere genau die gleiche Anzahl von Flanken, aufweisen. Durch das erfindungsgemäße Verfahren sind die oberhalb in Bezug auf den erfindungsgemäßen Delta-Sigma-D/A-Wandler erläuterten Vorteile in entsprechender Weise erzielbar. Ferner sind auch die oberhalb erläuterten Varianten und Weiterbildungen in entsprechender Weise realisierbar.

Weitere Vorteile und Zweckmäßigkeiten der Erfindung ergeben sich anhand der nachfolgenden Beschreibung von Ausführungsbeispielen unter Bezugnahme auf die beigefügten Figuren. Von den Figuren zeigen:
- Fig. 1a-1d:: verschiedene Signalverläufe eines Ausgangssignals eines herkömmlichen Delta-Sigma-D/A-Wandlers;
- Fig. 2:: eine schematische Darstellung der Funktionsweise eines herkömmlichen Delta-Sigma-D/A-Wandlers erster Ordnung;
- Fig. 3a, 3b:: zwei verschiedene, einen Satz von Signalmustern bildende Signalmuster gemäß einer ersten Ausführungsform der vorliegenden Erfindung;
- Fig. 3c-3e:: verschiedene, aus den in den Fig. 3a und 3b gezeigten Signalmustern gebildete Ausgangssignale;
- Fig. 3f:: eine schematische Darstellung der Erzeugung des Ausgangssignals gemäß der ersten Ausführungsform;
- Fig. 4a-4c:: drei verschiedene, einen Satz von Signalmustern bildende Signalmuster gemäß einer zweiten Ausführungsform der vorliegenden Erfindung;
- Fig. 5:: eine schematische Darstellung der Funktionsweise eines erfindungsgemäßen Delta-Sigma-D/A-Wandlers gemäß einer dritten Ausführungsform der vorliegenden Erfindung;
- Fig. 6:: eine Darstellung des Aufbaus von fünfzehn verschiedenen, einen Satz von Signal-mustern bildenden Signalmustern gemäß der dritten Ausführungsform der vorliegenden Erfindung; und
- Fig. 7:: eine schematische Darstellung eines Messgerätes zur Veranschaulichung einer Anwendung des erfindungsgemäßen Delta-Sigma-D/A-Wandlers.

In Fig. 2 ist die Funktionsweise eines herkömmlichen Delta-Sigma-D/A-Wandlers 20 dargestellt. Der Delta-Sigma-D/A-Wandler 20 weist einen als digitale Schaltung ausgebildeten Delta-Sigma-Modulator 22 auf. Der Delta-Sigma-Modulator 22 wiederum weist ein Register 24 mit einer Register-Bitstellenanzahl auf, die der Anzahl der Bitstellen des digitalwertigen Eingangssignals entspricht. Bei der dargestellten Ausführungsform handelt es sich um einen 16-Bit-Delta-Sigma-Modulator 22, so dass das digitalwertige Eingangssignal 16 Bit aufweist. Ferner weist der Delta-Sigma-Modulator 22 ein Summationsglied 26 auf, dem das digitalwertige Eingangssignal, das in Fig. 2 schematisch durch die Box 28 dargestellt ist, entsprechend einem Takt CLK zugeführt wird. Dem Summationsglied 26 wird ferner über eine Rückführschleife (engl.: feed back loop) 29 die in dem Register 24 enthaltene, digitale Zahl entsprechend dem Takt CLK zugeführt. Die bei der Summation in dem Summationsglied 26 erhaltene Zahl wird dann wieder entsprechend dem Takt CLK in das Register 24 geschrieben, wobei die bisher in dem Register enthaltene Zahl überschrieben wird. Das Register 24 weist dabei eine der Bitstellenanzahl des digitalwertigen Eingangssignals entsprechende Bitstellenanzahl, vorliegend also eine Bitstellenanzahl von 16, auf. Aufgrund der in dem Summationsglied 26 durchgeführten Summation kann sich auch eine um eins höhere Bitstellenanzahl, vorliegend also eine Bitstellenanzahl von 17, ergeben. Hierfür ist eine zusätzliche Overflow-Bitstelle (deutsch: Überlauf-Bitstelle) 30 vorgesehen, in die das höchstwertige Bit der Summe entsprechend dem Takt CLK geschrieben wird, falls die Summe eine Bitstellenanzahl von 17 aufweist. Weist die Summe dagegen nur eine, der Bitstellenanzahl des digitalwertigen Eingangssignals entsprechende Bitstellenanzahl auf, vorliegend also 16 Bitstellen, so wird eine "0" in die Overflow-Bitstelle 30 geschrieben.

Die (zeitabhängige, entsprechend dem Takt CLK wechselnde) Belegung der Overflow-Bitstelle 30 bildet zugleich das Ausgangssignal des Delta-Sigma-D/A-Wandlers 20, das entsprechend dem Takt CLK ausgegeben wird. Dies ist in Fig. 2 durch den Pfeil 32 und den schematisch angedeuteten Signalverlauf des Ausgangssignals dargestellt. Das Ausgangssignal ist ein binäres, entsprechend dem Takt CLK zeitdiskretes Signal, wobei die beiden, durch das Ausgangssignal annehmbaren Binärwerte als "0" und als "1" bezeichnet werden. Um ein analoges Signal zu erhalten, wird das Ausgangssignal anschließend durch einen analogen Tiefpassfilter 34, der vorliegend durch ein RC-Glied (Widerstands-Kondensator-Glied) gebildet wird, gefiltert. Nach der Filterung wird ein analoges Signal, das insbesondere durch einen analogen Spannungswert gebildet wird, erhalten. Dies ist in Fig. 2 durch den Pfeil 36 und das schematisch angedeutete, analoge Signal dargestellt.

Als Beispiel der Funktionsweise wird der Fall betrachtet, in dem der digitale Wert 1011 1111 1111 1111 in dem Register 24 steht und die Overflow-Bitstelle 30 den Wert "0" aufweist. Bei dem nächsten Takt wird ein Eingangswert von 0111 1111 1111 1111 durch das Summationsglied 26 zu dem über die Rückführschleife 29 aus dem Register 24 zugeführten Wert von 1011 1111 1111 1111 addiert, so dass als nächstes der Wert 0011 1111 1111 1110 in das Register 24 und in die Overflow-Bitstelle 30 der Wert "1" geschrieben werden. Der Wert von "1" der OverflowBitstelle 30 wird folglich als Ausgangssignal in diesem Takt ausgegeben.

Unter Bezugnahme auf Fig. 2 wurde ein 16-Bit-Delta-Sigma-Modulator erläutert. Wie aus dem Fachgebiet bekannt ist, benötigt der 16-Bit-Delta-Sigma-Modulator maximal 2¹⁶, d:h. 65.536 Taktzyklen des Taktes CLK, um einen 16 Bitstellen aufweisenden Eingangswert vollständig aus dem 16-Bit-Delta-Sigma-Modulator "auszuschieben". Die erläuterte Funktionsweise ist entsprechend, falls das Eingangssignal eine andere Bitstellenanzahl n aufweist und der Delta-Sigma-Modulator entsprechend durch einen n-Bit-Delta-Sigma-Modulator gebildet wird. In letzterem Fall benötigt der n-Bit-Delta-Sigma-Modulator maximal 2ⁿ Taktzyklen, um einen n Bitstellen aufweisenden Eingangswert vollständig aus dem n-Bit-Delta-Sigma-Modulator "auszuschieben".

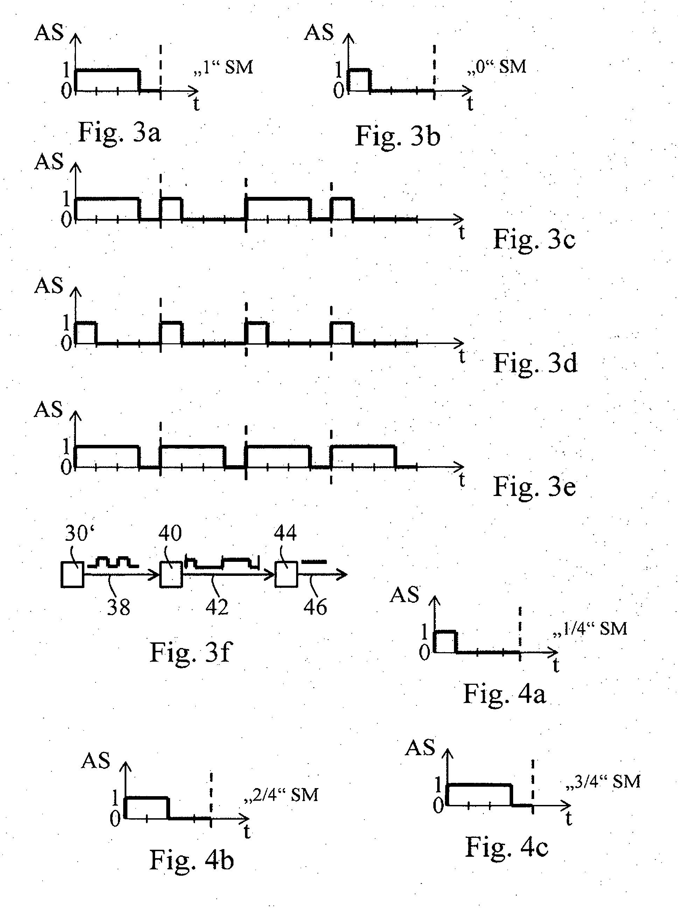

Gemäß einer ersten Ausführungsform der vorliegenden Erfindung wird das binäre, entsprechend einem Takt zeitdiskrete Ausgangssignal durch Aneinanderreihen von Signalmustern eines aus insgesamt zwei verschiedenen Signalmustern bestehenden Satzes gebildet. Die zwei, als "1" SM und "0" SM bezeichneten Signalmuster sind in den Fig. 3a und 3b dargestellt. Dabei ist allgemein in den Fig. 3a-3e, Fig. 4a-4c und Fig. 6 der jeweilige Signalverlauf des Signalmusters oder ggf. des Ausgangssignals, der als AS bezeichnet wird, über der Zeit t aufgetragen. Entlang der Zeitachse t sind die einzelnen Taktzyklen jeweils durch Striche angedeutet. Die beiden, in den Fig. 3a und 3b dargestellten Signalmuster "1" SM und "0" SM sind jeweils binär und können über einen Taktzyklus hinweg nur einen von zwei, als "1" und als "0" bezeichneten Binärwerten annehmen. Sie weisen beide eine Signalmuster-Taktlänge von vier Takten auf. Das in Fig. 3a dargestellte Signalmuster "1" SM nimmt dabei über die ersten drei Takte den Ausgangswert "1" an und über den vierten Takt den Ausgangswert "0" an. Dementsprechend weist dieses Signalmuster "1" SM einen über die vier Takte gebildeten Signalmuster-Mittelwert von 0,75 auf. Dabei ist zu berücksichtigen, dass die Angabe von 0,75 bzw. 75% nur eine Referenz ist, der tatsächliche Signalmuster-Mittelwert, der beispielsweise durch einen Spannungswert gebildet werden kann, von den tatsächlich für die "1" und die "0" ausgegebenen, physikalischen Werten (insbesondere Spannungswerten) abhängt. In dem vorliegenden Zusammenhang wird der Signalmuster-Mittelwert jedoch auf die abstrakten Binärwerte von "0" und "1" bezogen. Das in Fig. 3b dargestellte Signalmuster "0" SM nimmt über den ersten Takt den Ausgangswert "1" an und über die Takte zwei bis vier den Ausgangswert "0" an. Dementsprechend weist dieses Signalmuster "0" SM einen über die vier Takte gebildeten Signalmuster-Mittelwert von 0,25 auf.

In den Fig. 3c bis 3e sind beispielhaft verschiedene, durch Aneinanderreihen der Signalmuster "1" SM und "0" SM gebildete Ausgangssignale dargestellt. Die gebildeten Ausgangssignale sind dementsprechend ebenfalls binär und entsprechend dem Takt zeitdiskret. Das in Fig. 3c dargestellte Ausgangssignal wird durch abwechselndes Aneinanderreihen der Signalmuster "1" SM und "0" SM gebildet. Ein über die dargestellte Zeitdauer gebildeter Mittelwert des Ausgangssignals beträgt 0,5. Das in Fig. 3d dargestellte Ausgangssignal wird durch Aneinanderreihen ausschließlich des Signalmusters "0" SM gebildet. Ein über die dargestellte Zeitdauer gebildeter Mittelwert des Ausgangssignals beträgt 0,25. Dies ist gleichzeitig der niedrigste, durch Kombination der beiden Signalmuster "0" SM und "1" SM darstellbare Ausgangswert. Das in Fig. 3e dargestellte Ausgangssignal wird durch Aneinanderreihen ausschließlich des Signalmusters "1" SM gebildet. Ein über die dargestellte Zeitdauer gebildeter Mittelwert des Ausgangssignals beträgt 0, 75. Dies ist gleichzeitig der höchste, durch Kombination der beiden Signalmuster "0" SM und "1" SM darstellbare Ausgangswert.

Bei der ersten Ausführungsform wird ein, durch eine digitale Schaltung gebildeter n-Bit-Delta-Sigma-Modulator, dem ein n Bitstellen aufweisendes Eingangssignal zugeführt wird, in herkömmlicher Weise betrieben, so dass der n-Bit-Delta-Sigma-Modulator als Modulator-Ausgangssignal einen Bitstream ausgibt. Insbesondere kann der n-Bit-Delta-Sigma-Modulator durch den oberhalb, unter Bezugnahme auf Fig. 2 erläuterten 16-Bit-Delta-Sigma-Modulator 22 gebildet werden. Dieses Beispiel ist in Fig. 3f schematisch dargestellt, in dem die Overflow-Bitstelle 30' eines solchen 16-Bit-Delta-Sigma-Modulators dargestellt ist. Die Ausgabe des durch einen Bitstream gebildeten Modulator-Ausgangssignals des 16-Bit-Delta-Sigma-Modulators ist in Fig. 3f durch den Pfeil 38 und den schematisch angedeuteten Signalverlauf des Modulator-Ausgangssignals dargestellt. Dieses Modulator-Ausgangssignal wird einem Signalmuster-Generator 40 zugeführt. Durch den Signalmuster-Generator 40 wird immer dann, wenn das Modulator-Ausgangssignal den Wert "0" annimmt (bzw. einnimmt), das als "0" SM bezeichnete Muster ausgegeben und immer dann, wenn das Modulator-Ausgangssignal den Wert "1" annimmt, das als "1" SM bezeichnete Muster ausgegeben. Die Bestimmung des jeweils auszugebenden Musters kann in dem Signalmuster-Generator 40 mit Hilfe einer Lookup-Tabelle durchgeführt werden. Das von dem Signalmuster-Generator 40 ausgegebene Ausgangssignal ist in Fig. 3f durch den Pfeil 42 und den schematisch angedeuteten Signalverlauf des Ausgangssignals dargestellt. In der Figur ist dabei die Zeitbasis der bei den Pfeilen 38 und 42 dargestellten Signale nicht maßstäblich zueinander dargestellt. Dieses Ausgangssignal wird dann wieder einem Tiefpassfilter 44 zugeführt, der eine Filterung durchführt und ein analoges Signal ausgibt. Die Ausgabe des analogen Signals ist in Fig. 3f durch den Pfeil 46 und den schematisch angedeuteten Signalverlauf des analogen Signals dargestellt.

Dadurch, dass alle Signalmuster (hier: "0" SM und "1" SM) jeweils genau eine ansteigende und genau eine abfallende Flanke aufweisen und dass alle Signalmuster jeweils die gleiche Signalmuster-Taktlänge aufweisen, ist die Anzahl der Flanken über der Zeit sowie die Frequenz des Ausgangssignals (bei Betrachtung über mehrere Signalmuster-Taktlängen hinweg) unabhängig von dem jeweils dargestellten Wert konstant. Dies ist vorteilhaft in Bezug auf eine Korrektur eines durch eine Verzerrung der Flanken bedingten Fehlers sowie in Bezug auf eine (analoge) Filterung des Ausgangssignals. Wird ein entsprechender Delta-Sigma-D/A-Wandler in einem Gerät mit einem analogen Strom- oder Spannungsausgang zur Umwandlung eines von dem Gerät bestimmten, digitalwertigen Messwertes oder zur Umwandlung eines von dem Gerät bestimmten, digitalwertigen Stellwertes in ein analoges Strom- oder Spannungssignal verwendet, so besteht ein weiterer Vorteil darin, dass der Strom- oder Spannungswert aufgrund der Ausbildung der Signalmuster nicht vollständig auf null abfallen kann.

Indem bei der ersten Ausführungsform jeweils 4 Taktzyklen zur Ausgabe eines Signalmusters benötigt werden, wird der zugehörige Delta-Sigma-Modulator (hier: der 16-Bit-Delta-Sigma-Modulator) mit einem Modulatortakt betrieben, der einem Signalmustertakt, mit dem einzelne Signalmuster durch den Signalmuster-Generator 40 ausgegeben werden, entspricht. Vorliegend entspricht die Modulatortaktfrequenz (sowie die Signalmustertaktfrequenz) einem Viertel der Taktfrequenz. Entsprechend, wie es oberhalb erläutert wurde, benötigt der 16-Bit-Deltä-Sigma-Modulator maximal 2¹⁶, d.h. 65.536 Modulatortaktzyklen, um einen 16 Bitstellen aufweisenden Eingangswert vollständig aus dem 16-Bit-Delta-Sigma-Modulator "auszuschieben". Da für die Ausgabe eines Modulator-Ausgangswertes wiederum 4 Taktzyklen (zur Erzeugung des zugehörigen Signalmusters) benötigt werden, werden bei der ersten Ausführungsform maximal 2¹⁸, d.h. 262.144 Taktzyklen benötigt, um einen 16 Bitstellen aufweisenden Eingangswert vollständig aus dem Delta-Sigma-D/A-Wandler "auszuschieben". Weiterhin ist bei dieser Ausführungsform zu beachten, dass der untere Grenzwert des zulässigen Eingangswertebereichs auf einen gemittelten Ausgangswert von 0,25 (niedrigster, darstellbarer, gemittelter Ausgangswert) und der obere Grenzwert des zulässigen Eingangswertebereichs auf einen gemittelten Ausgangswert von 0,75 (höchster, darstellbarer, gemittelter Ausgangswert) "abgebildet" wird. Es erfolgt folglich eine Skalierung des zulässigen Eingangswertebereichs (von 0000 0000 0000 0000 bis 1111 1111 1111 1111) auf den reduzierten, gemittelten Ausgangswertebereich (von 0,25 bis 0,75). Diese Skalierung ist bei der weiteren Bearbeitung bzw. Auswertung des Ausgangssignals zu berücksichtigen.

Nachfolgend wird unter Bezugnahme auf die Figuren 4a-4c eine zweite Ausführungsform der vorliegenden Erfindung dargestellt. Dabei wird vorwiegend auf die Unterschiede gegenüber der ersten Ausführungsform eingegangen. Gemäß der zweiten Ausführungsform wird das binäre, entsprechend einem Takt zeitdiskrete Ausgangssignal durch Aneinanderreihen von Signalmustern eines aus insgesamt drei verschiedenen Signalmustern bestehenden Satzes gebildet. Diese drei Signalmuster sind in den Fig. 4a-4c dargestellt. Die drei, als "1/4" SM (vgl. Fig. 4a), "2/4" SM (vgl. Fig. 4b) und "3/4" SM (vgl. Fig. 4c) bezeichneten Signalmuster weisen jeweils eine Signalmuster-Taktlänge von 4 Takten auf. Der Signalverlauf des als "1/4" SM bezeichneten Signalmusters entspricht demjenigen des als "0" SM bezeichneten Signalmusters der ersten Ausführungsform und der Signalverlauf des als "3/4" SM bezeichneten Signalmusters entspricht demjenigen des als "1" SM bezeichneten Signalmusters. Das als "2/4" SM bezeichnete Signalmuster nimmt über die ersten zwei Takte den Ausgangswert "1" an und über den dritten und vierten Takt den Ausgangswert "0" an. Dementsprechend weist dieses Signalmuster "2/4" SM einen über die vier Takte gebildeten Signalmuster-Mittelwert von 0,5 auf. Auf diese Weise kann der Ausgangswertebereich von 0,25 bis 0,75 in Unterbereiche von 0,25 bis 0,5 und von 0,5 bis 0,75 unterteilt werden. Gemittelte Ausgangswerte zwischen 0,25 und 0,5 können folglich durch Modulation der als "1/4" SM und "2/4" SM bezeichneten Signalmuster und gemittelte Ausgangswerte zwischen 0,5 und 0,75 können durch Modulation der als "2/4" SM und "3/4" SM bezeichneten Signalmuster dargestellt werden. Um bei einem konkreten Eingangswert zu bestimmen, zwischen welchen zwei Signalmustern eine Modulation durchzuführen ist, werden gemäß der zweiten Ausführungsform so viele der höchstwertigen Bitstellen des Eingangssignals abgezweigt, wie zum Durchzählen der verschiedenen Signalmuster des Satzes erforderlich sind. Vorliegend sind dies, da der Satz drei verschiedene Signalmuster aufweist, zwei Bitstellen. Dementsprechend kann eine Zuordnung definiert werden, durch die dem Signalmuster "1/4" SM eine Belegung von "01" der ersten zwei Bitstellen, dem Signalmuster "2/4" SM eine Belegung von "10" der ersten zwei Bitstellen und dem Signalmuster "3/4" SM eine Belegung von 11 der ersten zwei Bitstellen des Eingangssignals zugeordnet wird. Bei dieser Zuordnung sind der Eingangswertebereich von 0000 0000 0000 0000 bis 0011 1111 1111 1111 und der Eingangswertebereich von 1100 0000 0000 0001 bis 1111 1111 1111 1111 nicht durch den betreffenden Delta-Sigma-D/A-Wandler darstellbar.

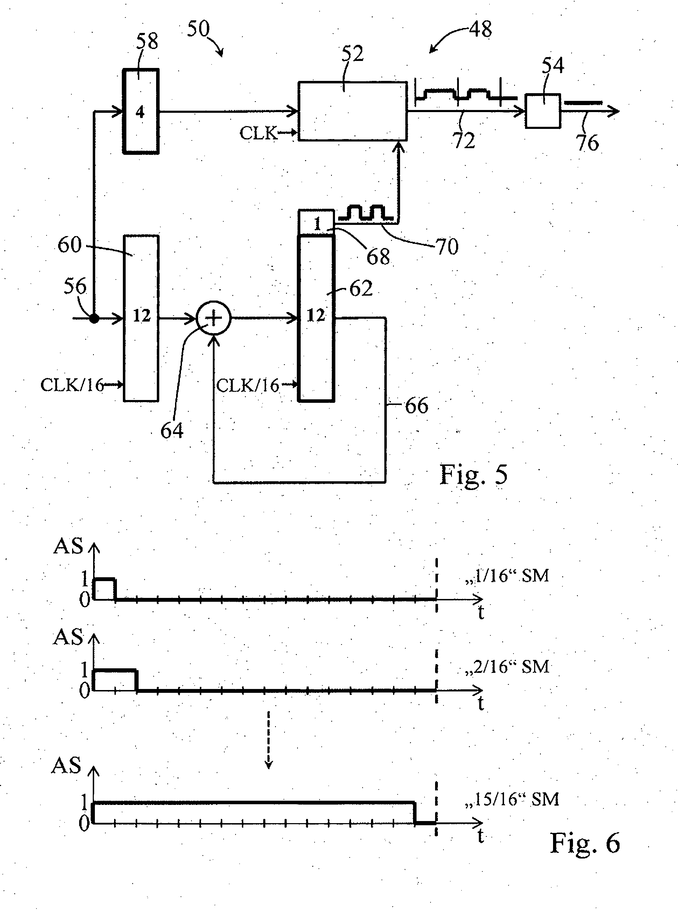

Nachfolgend wird die Erzeugung des Ausgangssignals gemäß der zweiten Ausführungsform kurz beschrieben. Eine ausführlichere Beschreibung in Bezug auf die Erzeugung des Ausgangssignals wird unter Bezugnahme auf Fig. 5 zur Erläuterung der dritten Ausführungsform, bei der die Signalmuster jeweils eine Signalmuster-Taktlänge von 16 Takten aufweisen, gegeben. Bei der zweiten Ausführungsform wird innerhalb des darstellbaren Eingangswertebereichs anhand der ersten beiden Bitstellen durch einen Signalmuster-Generator (z.B. unter Verwendung einer entsprechenden Lookup-Tabelle) bestimmt, welches das (gemäß der Zuordnung) zugehörige Signalmuster ist und dieses wird als untere Modulationsgröße verwendet. Sind die ersten beiden Bitstellen beispielsweise 01, so wird das Signalmuster "1/4" als untere Modulationsgröße verwendet. Das Signalmuster mit dem nächst höheren Signalmuster-Mittelwert wird dann als obere Modulationsgröße herangezogen. Bei dem vorliegenden Beispiel wäre dies dann das Signalmuster "2/4". Die (nach der Abzweigung verbleibenden Bitstellen des Eingangssignals werden einem n-Bit-Delta-Sigma-Modulator zugeführt, wobei n entsprechend der Anzahl der verbleibenden Bitstellen gewählt wird. Vorliegend ist der Delta-Sigma-Modulator als 14-Bit-Delta-Sigma-Modulator ausgebildet. Das Modulator-Ausgangssignal des 14-Bit-Delta-Sigma-Modulators wird an den Signalmuster-Generator gegeben. In Abhängigkeit von der Belegung der in dem Sigma-Delta-Modulator modulierten, verbleibenden Bitstellen des Eingangssignals weist das in einem Modulatortakt ausgegebene Modulator-Ausgangssignal ein entsprechendes Verhältnis von "0" en und "1" en auf. Die Modulatortaktfrequenz entspricht in dem vorliegenden Fall einem Viertel der Taktfrequenz, da jeweils vier Takte zur Ausgabe eines Signalmusters durch den Signalmuster-Generator benötigt werden. Durch den Signalmuster-Generator wird dann, wenn das Modulator-Ausgangssignal den Wert "0" aufweist, die untere Modulationsgröße ausgegeben und dann, wenn er das Modulator-Ausgangssignal den Wert "1" aufweist, die obere Modulationsgröße ausgegeben. Auf diese Weise wird der jeweilige Eingangswert durch Modulation der entsprechenden beiden Signalmuster dargestellt.

Wie anhand der Erläuterungen oberhalb deutlich wird, ist bei dem Delta-Sigma-D/A-Wandler gemäß der zweiten Ausführungsform im Wesentlichen nur ein Bereich von 25% bis 75% des durch 16 Bitstellen darstellbaren Eingangswertebereiches möglich. Dieser wird dann auf einen Ausgangswertebereich von 0,25 bis 0,75 abgebildet. Dies ist bei einer gegebenenfalls durchzuführenden Vorbearbeitung des Eingangssignals und bei der weiteren Bearbeitung des Ausgangssignals zu berücksichtigen. Insbesondere kann das Eingangssignal entsprechend an diesen zulässigen Eingangswertebereich angepasst werden. Die Tatsache, dass nur ein Teilbereich des durch 16 Bitstellen darstellbaren Eingangswertebereiches darstellbar ist, ist insbesondere bei Verwendung des Delta-Sigma-D/A-Wandlers zur Erzeugung eines Stromsignals gemäß dem 4-20 mA Standard relativ unproblematisch, da hier beispielsweise der untere Bereich von 0 mA bis kurz unterhalb von 4 mA in der Regel nicht dargestellt werden muss.

Durch die zweite Ausführungsform können insbesondere die nachfolgenden, zusätzlichen Vorteile erzielt werden: Dadurch, dass gemäß der zweiten Ausführungsform zwei Bitstellen des Eingangssignals abgezweigt werden und nur die verbleibenden Bitstellen durch einen Delta-Sigma-Modulator moduliert werden, kann der Delta-Sigma-Modulator mit weniger Bitstellen ausgebildet werden. Dementsprechend sind für die Bereitstellung des Delta-Sigma-Modulators weniger Ressourcen erforderlich. Ferner kann der Delta-Sigma-Modulator mit einer niedrigeren Modulatortaktfrequenz betrieben werden, was zu einem reduzierten Energieverbrauch führt. Weiterhin ist vorteilhaft, dass dadurch, dass die ersten beiden, höchstwertigen Bitstellen direkt dem Signalmuster-Generator zugeführt werden, das von dem Signalmuster-Generator ausgegebene Ausgangssignal starken Änderungen des Eingangssignals schnell folgen kann.

Diese, in Bezug auf die zweite Ausführungsform erläuterten Vorteile werden bei der dritten Ausführungsform noch verstärkt, bei der die einzelnen Signalmuster des Satzes jeweils eine Signalmuster-Taktlänge von 16 Takten aufweisen. Bei der nachfolgenden Erläuterung der dritten Ausführungsform wird vorwiegend auf die Unterschiede gegenüber der zweiten Ausführungsform eingegangen. Der Satz von Signalmustem weist bei der dritten Ausführungsform fünfzehn verschiedene Signalmuster auf, die jeweils eine Signalmuster-Taktlänge von 16 Takten aufweisen und deren Aufbau in Fig. 6 dargestellt ist. Das Signalmuster mit dem niedrigsten Signalmuster-Mittelwert, das als "1/16" SM bezeichnet ist, nimmt über den ersten Takt den Ausgangswert "1" an und von dem zweiten bis zu dem sechzehnten Takt den Ausgangswert "0" an. Das Signalmuster "1/16" SM weist einen über die sechzehn Takte gebildeten Mittelwert von 1/16 auf. Das Signalmuster mit dem nächst höheren Signalmuster-Mittelwert, das als "2/16" SM bezeichnet wird, nimmt gegenüber dem Signalmuster "1/16" SM um genau einen Takt länger, nämlich von dem ersten bis zu dem zweiten Takt, den Ausgangswert "1" an. Das Signalmuster "2/16" SM weist einen über die sechzehn Takte gebildeten Mittelwert von 2/16 auf. Dieses Schema setzt sich fort, wobei jedes Signalmuster des Satzes gegenüber dem Signalmuster mit dem nächst niedrigeren Signalmuster Mittelwert um genau einen Takt länger den Ausgangswert "1" annimmt. Das Signalmuster mit dem höchsten Signalmuster-Mittelwert ist das in Fig. 6 unten dargestellte Signalmuster "15/16" SM, das von dem ersten bis zu dem fünfzehnten Takt den Ausgangswert "1" und über den sechzehnten Takt den Ausgangswert "0" annimmt. Das Signalmuster "15/16" weist folglich einen über die sechzehn Takte gebildeten Signalmuster-Mittelwert von 15/16 auf. Auf diese Weise kann der Ausgangswertebereich von 1/16 bis 15/16 in 14 Unterbereiche mit jeweils einer Breite von 1/16 unterteilt werden. Gemittelte Ausgangswerte zwischen 1/16 und 2/16 können beispielsweise durch eine Modulation der als "1/16" SM und "2/16" SM bezeichneten Signalmuster dargestellt werden. Wiederum werden wie bei der zweiten Ausführungsform so viele der höchstwertigen Bitstellen des Eingangssignals abgezweigt, wie zum Durchzählen der verschiedenen Signalmuster erforderlich sind. Vorliegend sind dies, da der Satz fünfzehn verschiedene Signalmuster aufweist, vier Bitstellen. Ferner wird wiederum eine Zuordnung definiert, durch die in dem vorliegenden Fall dem Signalmuster "1/16" SM eine Belegung von 0001, dem Signalmuster "2/16" SM eine Belegung von 0010, usw., dem Signalmuster "8/16" SM eine Belegung von 1000, usw. und dem Signalmuster "15/16" eine Belegung von 1111 zugeordnet werden. Dementsprechend sind der Eingangswertebereich von 0000 0000 0000 0000 bis 0000 1111 1111 1111 und der Eingangswertebereich von 1111 0000 0000 0001 bis 1111 1111 1111 1111 nicht durch den Delta-Sigma-D/A-Wandler darstellbar. Der nicht darstellbare Eingangswertebereich, der im Wesentlichen den Bereich von 0 bis 1/16 und von 15/16 bis 16/16 umfasst, ist gegenüber der zweiten Ausführungsform deutlich verkleinert.

Nachfolgend wird die Erzeugung des Ausgangssignals gemäß der dritten Ausführungsform unter Bezugnahme auf Fig. 5 beschrieben. Das 16 Bitstellen aufweisende Eingangssignal weist nach der Abzweigung der vier ersten Bitstellen noch 12 verbleibende Bitstellen auf, so dass ein 12-Bit-Delta-Sigma-D/A-Wandler zur Modulation der verbleibenden Bitstellen vorzusehen ist. Der in Fig. 5 dargestellte Delta-Sigma-D/A-Wandler 48 weist einen als digitale Schaltung ausgebildeten, 12-Bit-Delta-Sigma-Modulator 50, einen Signalmuster-Generator 52 und einen analogen Tiefpassfilter 54 auf. Von dem Eingangssignal, das dem Delta-Sigma-D/A-Wandler 48 zugeführt wird, werden zunächst die ersten vier (d.h. die vier höchstwertigen Bitstellen) abgezweigt. Dies ist in Fig. 5 schematisch durch die Abzweigung 56, einen vier Bitstellen aufweisenden Block des Eingangssignals 58 und einen zwölf Bitstellen aufweisenden Block des Eingangssignals 60 dargestellt. Die ersten vier, abgezweigten Bitstellen werden dem Signalmuster-Generator 52 direkt zugeführt. In Abhängigkeit von der Belegung der abgezweigten (vier ersten) Bitstellen wird in dem Signalmuster-Generator 52 entsprechend der Zuordnung (insbesondere unter Verwendung einer Lookup-Tabelle) das zugehörige Signalmuster bestimmt. Dieses wird dann als untere Modulationsgröße in dem Signalmuster-Generator 52 verwendet. Sind die ersten vier Bitstellen beispielsweise 1000, so wird das Signalmuster "8/16" SM als untere Modulationsgröße verwendet. Das Signalmuster mit dem nächst höheren Signalmuster-Mittelwert wird dann als obere Modulationsgröße verwendet. Bei dem vorliegenden Beispiel wäre dies dann das Signalmuster "9/16" SM.

Die (nach der Abzweigung) verbleibenden Bitstellen des Eingangssignals werden dem 12-Bit-Delta-Sigma-Modulator 50 zugeführt. Der Delta-Sigma-Modulator 50 wird entsprechend wie der unter Bezugnahme auf Fig. 2 erläuterte Delta-Sigma-Modulator 22 betrieben. Die Modulatortaktfrequenz des 12-Bit-Delta-Sigrna-Modulators entspricht der Signalmustertaktfrequenz, mit der die einzelnen, 16 Takte langen Signalmuster durch den Signalmuster-Generator 52 ausgegeben werden. Die Modulatortaktfrequenz entspricht in dem vorliegenden Beispiel dementsprechend 1/16 der Taktfrequenz. Dadurch kann der Verbrauch der elektrischen Leistung noch weiter (im Vergleich zu der zweiten Ausführungsform) reduziert werden. Weiterhin ist vorteilhaft, dass nur ein 12-Bit-Delta-Sigma-Modulator 50 (im Vergleich zu einem 14-Bit-Delta-Sigma-Modulator bei der zweiten Ausführungsform) benötigt wird, so dass auch hier Ressourcen gespart werden. Der 12-Bit-Delta-Sigma-Modulator 50 weist, entsprechend wie der Delta-Sigma-Modulator 22 der Fig. 2, ein Register 62 mit einer Bitstellenanzahl von zwölf, ein Summationsglied 64, eine Rückführschleife (engl.: feed back loop) 66 und eine Overflow-Bitstelle 68 auf. Dem Summationsglied 64 werden mit jedem Modulatortakt CLK/16 die verbleibenden (zwölf) Bitstellen des Eingangssignals und die in dem Register 62 enthaltene, digitale Zahl (von zwölf Bitstellen) zugeführt. Die bei der Summation in dem Summationsglied 64 erhaltene, digitale Zahl wird dann wieder entsprechend dem Modulatortakt CLK/16 in das Register 62 geschrieben, wobei die bisher in dem Register 62 enthaltene Zahl überschrieben wird. Entsprechend wie bei dem Delta-Sigma-Modulator 22 der Fig. 2 wird dann, wenn die erhaltene Summe eine Bitstellenanzahl von 13 mit einer "1" an dem höchstwertigen Bit aufweist, eine "1" in die Overflow-Bitstelle 68 geschrieben. Weist die erhaltene Summe eine Bitstellenahzahl von 12 auf, so wird eine "0" in die Overflow-Bitstelle 68 geschrieben.

Die (zeitabhängige, entsprechend dem Modulatortakt CLK/16 wechselnde) Belegung der Overflow-Bitstelle 68 bildet zugleich das Modulator-Ausgangssignal des 12-Bit-Delta-Sigma-Modulatbrs 50, das entsprechend dem Modulatortakt CLK/16 ausgegeben wird. Dies ist in Fig. 5 durch den Pfeil 70 und den schematisch angedeuteten Signalverlauf des Modulator-Ausgangssignals dargestellt. Das Modulator-Ausgangssignal ist ein binäres, entsprechend dem Modulatortakt CLK/16 zeitdiskrete Signal. Es erfüllt dabei die Beziehung, dass dessen (über mehrere Modulatortakte gebildeter) Mittelwert dem Wert der verbleibenden (zwölf) Bitstellen, die dem 12-Bit-Delta-Sigma-Modulator zugeführt werden, entspricht. Das Modulator-Ausgangssignal wird dem Signalmuster-Generator 52 zugeführt. Der Signälmustertakt des Signalmuster-Generators 52, mit dem die einzelnen Signalmuster ausgegeben werden, ist dabei auf den Modulatortakt des 12-Bit-Delta-Sigma-Modulators 50 abgestimmt. Der Signalmuster-Generator 52 führt basierend auf dem Modulator-Ausgangssignal die Modulation zwischen der unteren Modulationsgröße und der oberen Modulationsgröße durch (wobei die Bestimmung der unteren und der oberen Modulationsgröße, wie oberhalb erläutert wird, anhand der ersten vier, abgezweigten Bitstellen erfolgt). Insbesondere wird durch den Signalmuster-Generätor 52 dann, wenn das Modulator-Ausgangssignal den Wert "0" aufweist, die untere Modulationsgröße ausgegeben und dann, wenn das Modulator-Ausgangssignal den Wert "1" aufweist, die obere Modulationsgröße ausgegeben. Auf diese Weise wird der Eingangswert des Eingangssignals durch Modulation der entsprechenden beiden Signalmuster dargestellt. Das Ausgangssignal, das durch Aneinanderreihen der jeweils bestimmten Signalmuster gebildet wird, ist ein binäres, entsprechend dem Takt CLK zeitdiskretes Signal, dessen (über mehrere Takte, insbesondere über mehrere Signalmuster-Taktlängen gebildeter) Mittelwert dem Eingangswert des Eingangssignals entspricht. Die Ausgabe des Ausgangssignals durch den Signalmuster-Generator 52 ist in Fig. 5 durch den Pfeil 72 und den schematisch angedeuteten Signalverlauf des Ausgangssignals dargestellt. In der Figur ist dabei die Zeitbasis der bei den Pfeilen 70 und 72 dargestellten Signale nicht maßstäblich zueinander dargestellt. Um ein analoges (kontinuierliches) Signal zu erhalten, wird das Ausgangssignal anschließend durch den analogen Tiefpassfilter 54 gefiltert. Ist das Signal über eine galvanische Trennung zu übertragen, so wird vorzugsweise das Ausgangssignal vor Durchführung der Filterung über die galvanische Trennung übertragen und erst anschließend die Filterung durchgeführt. Nach der Filterung wird ein analoges Signal, das insbesondere durch einen analogen Spannungswert gebildet wird, erhalten. Dies ist in Fig. 5 durch den Pfeil 76 und das schematisch angedeutete, analoge Signal dargestellt.

Ein weiterer Vorteil, der durch die dritte Ausführungsform gegenüber der ersten Ausführungsform erzielt wird, besteht in der erforderlichen Anzahl von Taktzyklen, um einen 16 Bitstellen aufweisenden Eingangswert vollständig aus dem Delta-Sigma-D/A-Wandler 48 auszuschieben. Der 12-Bit-Delta-Sigma-Modulator 50 benötigt 2¹², d.h. 4.096 Modulatortaktzyklen, um die zwölf verbleibenden Bitstellen des jeweiligen Eingangswertes vollständig "auszuschieben". Da für die Ausgabe eines Modulator-Ausgangswertes wiederum 16, d.h. 2⁴ Taktzyklen benötigt werden, werden insgesamt 2¹⁶, d.h. 65.536 Taktzyklen zum Ausschieben eines 16 Bitstellen aufweisenden Eingangswertes benötigt. Das heißt, es wird keine Aufweitung bzw. Verlangsamung gegenüber einem herkömmlichen16-Bit-Delta-Sigma-Modulator, wie er beispielsweise unter Bezugnahme auf Fig. 2 erläutert wurde, verursacht. Diese Anzahl von 2¹⁶ Taktzyklen wird auch bei dem zweiten Ausführungsbeispiel benötigt (2² mal 2¹⁴ Taktzyklen). Gegenüber der zweiten Ausführungsform ist aber, wie oberhalb erläutert wird, der darstellbare Eingangswertebereich deutlich erhöht. Weiterhin ist gegenüber der zweiten Ausführungsform nur ein Delta-Sigma-Modulator mit niedrigerer Bitstellehanzahl erforderlich.

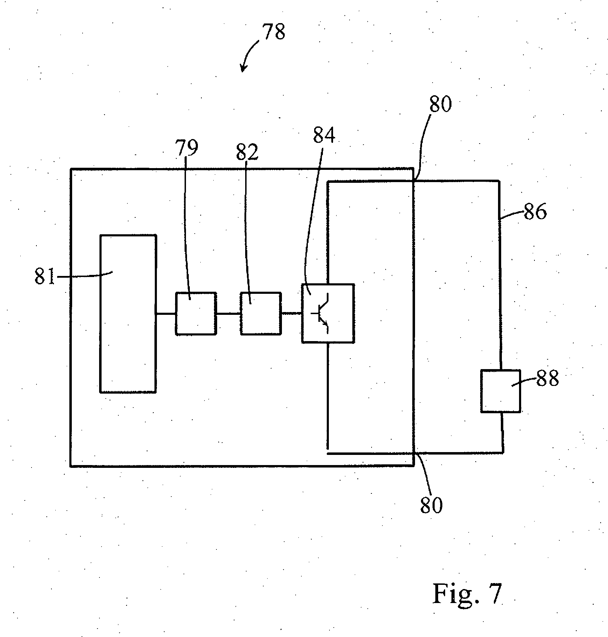

Nachfolgend wird unter Bezugnahme auf Fig. 7 eine beispielhafte Anwendung eines erfindungsgemäßen Delta-Sigma-D/A-Wandlers 79 in einem Messgerät 78, durch das ein analoges Stromsignal gemäß dem 4-20 mA Standard zur Übermittlung eines in dem Messgerät 78 erfassten Messwertes über einen analogen Strormausgang 80 des Messgerätes 78 ausgebbar ist, erläutert. Dabei sind in Fig. 7 nur die zur Erläuterung der Erfindung wesentlichen Komponenten dargestellt. Das Messgerät 78 weist eine Steuerungseinheit 81 auf, die den zur übermittelnden Messwert als digitalwertiges Signal ausgibt. Dieses digitalwertige Signal bildet das Eingangssighals des erfindungsgemäßen Delta-Sigma-D/A-Wändlers 79. Wie oberhalb erläutert wird, wird das Eingangssignal in ein analoges Signal, das vorliegend durch ein Spannungssignal, das einem, an dem analogen Stromausgang 80 einzustellenden Stromwert entspricht, gewandelt. Entsprechend diesem Spannungssignal wird in einer Stromregelschaltung 82, der gegebenenfalls auch eine Rückkopplungsgröße eines tatsächlich an dem analogen Stromausgang 80 eingestellten Stromwertes zugeführt wird, eine Stellgröße an ein Stellglied 84 (hier: einen Transistor) gegeben. Durch das Stellglied 84 wird dann entsprechend der Stellgröße ein Stromwert in einer, an dem analogen Stromausgang 80 angeschlossenen Stromschleife 86 eingestellt. Auf diese Weise kann der in dem Messgerät 78 erfasste Messwert an einen Empfänger 88, wie beispielsweise an ein Steuergerät, der/das an der Stromschleife 86 angeschlossen ist, übermittelt werden.

Die vorliegende Erfindung ist nicht auf die in den Figuren erläuterten Ausführungsbeispiele beschränkt. Insbesondere kann vorgesehen sein, dass das Eingangssignal auch mehr oder weniger als 16 Bitstellen aufweist. Ferner kann beispielsweise auch das Verhältnis zwischen abgezweigten und verbleibenden Bitstellen des Eingangssignals anders gewählt werden.

## Patentansprüche

1. Delta-Sigma-D/A-Wandler, durch den ein digitalwertiges Eingangssignal in ein binäres, entsprechend einem Takt (CLK) zeitdiskretes Ausgangssignal wandelbar ist, wobei durch einen, über mehrere Takte (CLK) gebildeten Mittelwert des Ausgangssignals der Wert des Eingangssignals analog darstellbar ist, wobei der Delta-Sigma-D/A-Wandler derart ausgebildet ist, dass er im Einsatz das Ausgangssignal durch Aneinanderreihen von Signalmustem ("0" SM, "1" SM; "1/4" SM, "2/4" SM, "3/4" SM; "1/16" SM, "2/16" SM, ... "15/16" SM) eines Satzes von Signalmustem bereitstellt, wobei die Signalmuster des Satzes jeweils binär sind, entsprechend dem Takt (CLK) zeitdiskret sind und sich über eine Signalmuster-Taktlänge von mehreren Takten erstrecken, wobei mindestens zwei Signalmuster des Satzes voneinander unterschiedliche Signalmuster-Mittelwerte, die über die jeweilige Signalmuster-Taktlänge gebildet werden, aufweisen, wobei alle Signalmuster des Satzes jeweils im Wesentlichen die gleiche Anzahl, insbesondere genau die gleiche Anzahl, von Flanken (2, 3) aufweisen und wobei alle Signalmuster ("1/4" SM, "2/4" SM, "3/4" SM; "1/16" SM, "2/16" SM, ... "15/16" SM) des Satzes eine Signalmuster-Taktlänge von m Takten aufweisen, **dadurch gekennzeichnet, dass** der Satz m-1 verschiedene Signalmuster mit jeweils unterschiedlichen Signalmuster-Mittelwerten aufweist, dass das Signalmuster ("1/4" SM; "1/16" SM) mit dem niedrigsten SignalmusterMittelwert genau einen Takt lang den hohen der zwei zur Verfügung stehenden Binärwerte und die verbleibenden m-1 Takte den niedrigen Binärwert annimmt, und dass jedes Signalmuster des Satzes gegenüber dem Signalmuster mit dem nächst niedrigeren SignalmusterMittelwert um genau einen Takt länger den hohen Binärwert annimmt.

2. Delta-Sigma-D/A-Wandler gemäß Anspruch 1, **dadurch gekennzeichnet, dass** alle Signalmuster ("0" SM, "1" SM; "1/4" SM, "2/4" SM, "3/4" SM; "1/16" SM, "2/16" SM, ... "15/16" SM) des Satzes jeweils die gleiche Anzahl von ansteigenden Flanken (2) und jeweils diese gleiche Anzahl von abfallenden Flanken (3) aufweisen.

3. Delta-Sigma-D/A-Wandler gemäß Anspruch 1 oder 2, **dadurch gekennzeichnet, dass** alle Signalmuster ("0" SM, "1" SM; "1/4" SM, "2/4" SM, "3/4" SM; "1/16" SM, "2/16" SM, ... "15/16" SM) des Satzes jeweils die gleiche Signalmuster-Taktlänge aufweisen.

4. Delta-Sigma-D/A-Wandler gemäß einem der vorangehenden Ansprüche, **dadurch gekennzeichnet, dass** alle Signalmuster ("0" SM, "1" SM; "1/4" SM, "2/4" SM, "3/4" SM; "1/16" SM, "2/16" SM, ... "15/16" SM) des Satzes jeweils genau eine ansteigende (2) und genau eine abfallende Flanke (3) aufweisen.

5. Delta-Sigma-D/A-Wandler gemäß einem der vorangehenden Ansprüche, **dadurch gekennzeichnet, dass** alle Signalmuster ("0" SM, "1" SM; "1/4" SM, "2/4" SM, "3/4" SM; "1/16" SM, "2/16" SM, ... "15/16" SM) des Satzes jeweils unterschiedliche Signalmuster-Mittelwerte aufweisen.

6. Delta-Sigma-D/A-Wandler gemäß einem der vorangehenden Ansprüche, **dadurch gekennzeichnet, dass** der Delta-Sigma-D/A-Wandler einen digitalen Delta-Sigma-Modulator (22; 50), durch den zumindest ein Teil des digitalwertigen Eingangssignals modulierbar ist, aufweist.

7. Delta-Sigma-D/A-Wandler gemäß Anspruch 6, **dadurch gekennzeichnet, dass** der Delta-Sigma-D/A-Wandler derart ausgebildet ist, dass von dem digitalwertigen Eingangssignal eine vorbestimmte Stellenanzahl der höchstwertigen Bitstellen abzweigbar ist und die verbleibenden Bitstellen dem digitalen Delta-Sigma-Modulator (50) zur Erzeugung eines binären, entsprechend einem Modulatortakt (1/16 CLK) zeitdiskreten Modulator-Ausgangssignals zuführbar sind.

8. Delta-Sigma-D/A-Wandler gemäß Anspruch 7, **dadurch gekennzeichnet, dass** eine Zuordnung definiert ist, durch die jedem Signalmuster ("1/4" SM, "2/4" SM, "3/4" SM; "1/16" SM, "2/16" SM, ... "15/16" SM) des Satzes jeweils eine, dessen Signalmuster-Mittelwert entsprechende Belegung der abzweigbaren, höchstwertigen Bitstelle(n) des digitalwertigen Eingangssignals zugeordnet wird, dass der Delta-Sigma-D/A-Wandler einen Signalmuster-Generator (52) aufweist, durch den in Abhängigkeit von der jeweiligen Belegung der abgezweigten, höchstwertigen Bitstelle(n) entsprechend der Zuordnung das zugehörige Signalmuster bestimmbar ist, und dass dieses bestimmte Signalmuster durch den Signalmuster-Generator (52) als untere Modulationsgröße zur Bildung des Ausgangssignals ausgebbar ist.

9. Delta-Sigma-D/A-Wandler gemäß Anspruch 8, **dadurch gekennzeichnet, dass** das Signalmuster ("1/4" SM, "2/4" SM, "3/4" SM; "1/16" SM, "2/16" SM,..."15/16" SM) mit dem nächst höheren Signalmuster-Mittelwert im Vergleich zu dem Signalmuster-Mittelwert des als untere Modulationsgröße bestimmten Signalmusters durch den Signalmuster-Generator (52) als obere Modulationsgröße zur Bildung des Ausgangssignals ausgebbar ist.

10. Delta-Sigma-D/A-Wandler gemäß Anspruch 9, **dadurch gekennzeichnet, dass** das Modulator-Ausgangssignal des digitalen Delta-Sigma-Modulators (50) dem Signalmuster-Generätor (52) zuführbar ist und dass die Modulation zwischen der unteren Modulationsgröße und der oberen Modulationsgröße in Abhängigkeit von dem Modulator-Ausgangssignal durchgeführt wird.

11. Verwendung eines Delta-Sigma-D/A-Wandlers (48; 79) gemäß einem der vorangehenden Ansprüche in einem Gerät (78) mit einem analogen Strom- oder Spannungsausgang (80) zur Umwandlung eines, von dem Gerät (78) bestimmten, digitalwertigen Messwertes oder zur Umwandlung eines, von dem Gerät bestimmten, digitalwertigen Stellwertes in ein analoges Strom- oder Spannungssignal, das über den analogen Strom- oder Spannungsausgang (80) ausgebbar ist.

12. Verwendung gemäß Anspruch 11, **dadurch gekennzeichnet, dass** die Umwandlung des Messwertes oder des Stellwertes in ein Stromsignal, insbesondere in ein Stromsignal gemäß dem 4-20 mA Standard, erfolgt.

13. Messgerät mit einem analogen Strom- oder Spannungsausgang (80), aufweisend einen Delta-Sigma-D/A-Wandler (79) gemäß einem der Ansprüche 1 bis 10, wobei dem Delta-Sigma-D/A-Wandler (79) ein in dem Messgerät (78) bestimmter, digitalwertiger Messwert als digitalwertiges Eingangssignal zuführbar ist und das Ausgangssignal des Delta-Sigma-D/A-Wandlers zur Erzeugung eines, dem digitalwertigen Messwert entsprechenden, analogen Strom- bzw. Spannungssignals an dem analogen Strom- bzw. Spannungsausgang (80) ausgebbar ist.

14. Steuergerät mit einem analogen Strom- oder Spannungsausgang, aufweisend einen Delta-Sigma-D/A-Wandler (48) gemäß einem der Ansprüche 1 bis 10, wobei dem Delta-Sigma-D/A-Wandler (48) ein, in dem Steuergerät bestimmter, digitalwertiger Stellwert als digitalwertiges Eingangssignal zuführbar ist und das Ausgangssignal des Delta-Sigma-D/A-Wandlers zur Erzeugung eines, dem digitalwertigen Stellwert entsprechenden, analogen Strom- bzw. Spannungssignals an dem analogen Strom- bzw. Spannungsausgang ausgebbar ist.

## Claims

1. Delta-sigma digital to analog converter by means of which a digital input signal can be converted to a binary discrete-time output signal according to a clock (CLK), wherein the value of the input signal can be represented in an analog manner using an average value for the output signal which is formed over several clocks (CLK),
wherein the delta-sigma digital to analog converter is designed in such a way that, during operation, it makes the output signal available through the juxtaposition of signal patterns ("0" SM, "1" SM, "1/4" SM, "2/4" SM, "3/4" SM, "1/16" SM, "2/16" SM, ..., "15/16" SM) of a set of signal patterns, wherein the signal patterns of the set are binary in each case, are discrete-time according to the clock (CLK) and extend over a signal pattern cycle length of several clocks, wherein at least two signal patterns of the set have signal pattern mean values which are different from one another and which are formed over the individual signal pattern cycle length, wherein all the signal patterns of the set have essentially the same number of edges (2, 3), particularly exactly the same number of edges, and wherein all the signal patterns ("1/4" SM, "2/4" SM, "3/4" SM, "1/16" SM, "2/16" SM, ..., "15/16" SM) of the set have a signal pattern cycle length of m clocks, **characterized in that** the set m-1 has different signal patterns with different signal pattern average values in each case, **in that** the signal pattern ("1/4" SM, "1/16" SM) with the lowest signal pattern average value adopts the high value of the two binary values available for a period of exactly one clock and then adopts the low binary value for the remaining m-1 clocks, and **in that** every signal pattern of the set adopts the high binary value for exactly one clock longer compared to the signal pattern with the next lowest signal pattern average value.

2. Delta-sigma digital to analog converter as claimed in Claim 1, **characterized in that** all signal patterns ("0" SM, "1" SM, "1/4" SM, "2/4" SM, "3/4" SM, "1/16" SM, "2/16" SM, ..., "15/16" SM) of the set have the same number of rising edges (2) and the same number of falling edges (3) in each case.

3. Delta-sigma digital to analog converter as claimed in Claim 1 or 2, **characterized in that** all the signal patterns ("0" SM, "1" SM, "1/4" SM, "2/4" SM, "3/4" SM, "1/16" SM, "2/16" SM, ..., "15/16" SM) of the set have the same signal pattern clock length in each case.

4. Delta-sigma digital to analog converter as claimed in one of the previous claims, **characterized in that** all the signal patterns ("0" SM, "1" SM, "1/4" SM, "2/4" SM, "3/4" SM, "1/16" SM, "2/16" SM, ..., "15/16" SM) of the set have exactly one rising (2) and exactly one falling (3) edge in each case.

5. Delta-sigma digital to analog converter as claimed in one of the previous claims, **characterized in that** all the signal patterns ("0" SM, "1" SM, "1/4" SM, "2/4" SM, "3/4" SM, "1/16" SM, "2/16" SM, ..., "15/16" SM) of the set have different signal pattern average values in each case.

6. Delta-sigma digital to analog converter as claimed in one of the previous claims, **characterized in that** the delta-sigma digital to analog converter has a digital delta-sigma modulator (22, 50), by means of which at least a part of the digital input signal can be modulated.

7. Delta-sigma digital to analog converter as claimed in Claim 6, **characterized in that** the delta-sigma digital to analog converter is designed in such a way that it is possible to divert a predefined number of highest-value bit positions from the digital input signal and that it is possible to supply the remaining bit positions to the digital delta-sigma modulator (50) to generate a binary discrete-time modulator output signal according to a modulator clock (1/16 CLK).

8. Delta-sigma digital to analog converter as claimed in Claim 7, **characterized in that** an assignment is defined via which each signal pattern ("1/4" SM, "2/4" SM, "3/4" SM, "1/16" SM, "2/16" SM, ..., "15/16" SM) of the set is assigned a configuration of the divertable, highest-value bit position(s) of the digital input signal, which corresponds to the signal pattern average value, **in that** the delta-sigma digital to analog converter has a signal pattern generator (52) by means of which the corresponding signal pattern can be determined depending on the respective configuration of the diverted, highest-value bit position(s) according to the assignment, and **in that** this determined signal pattern can be output by the signal pattern generator (52) as the lower modulation variable for the generation of the output signal.

9. Delta-sigma digital to analog converter as claimed in Claim 8, **characterized in that** the signal pattern ("1/4" SM, "2/4" SM, "3/4" SM, "1/16" SM, "2/16" SM, ..., "15/16" SM) with the next highest signal pattern medium value compared with the signal pattern average value of the signal pattern determined as the lower modulation variable can be output by the signal pattern generator (52) as the upper modulation variable for the generation of the output signal.

10. Delta-sigma digital to analog converter as claimed in Claim 9, **characterized in that** the modulator output signal of the digital delta-sigma modulator (50) can be supplied to the signal pattern generator and that the modulation between the lower modulation variable and the upper modulation variable is performed depending on the modulator output signal.

11. Use of a delta-sigma digital to analog converter (48, 79) as claimed in one of the previous claims in a device (78) with an analog current or signal output (80) for the conversion of a digital measured value, determined by the device (78), or for the conversion of a digital actuating variable, determined by the device, into an analog current or voltage signal which can be output via the analog current or voltage output (80).

12. Use as claimed in Claim 11, **characterized in that** the measured value or the actuating value is converted into a current signal, particularly into a current signal in accordance with the 4-20 mA standard.

13. Measuring device with an analog current or voltage output (80), featuring a delta-sigma digital to analog converter (79) in accordance with one of the Claims 1 to 10, wherein the delta-sigma digital to analog converter (79) can be supplied with a digital measured value, which is determined in the measuring device (78), as a digital input signal, and the output signal of the delta-sigma digital to analog converter can be output to generate an analog current or voltage signal, which corresponds to the digital measured value, at the analog current output or voltage output (80).

14. Controller with an analog current or voltage output, featuring a delta-sigma digital to analog converter (48) in accordance with one of the Claims 1 to 10, wherein the delta-sigma digital to analog converter (48) can be supplied with a digital actuating value, which is determined in the controller, as a digital input signal, and the output signal of the delta-sigma digital to analog converter can be output to generate an analog current or voltage signal, which corresponds to the digital actuating value, at the analog current output or voltage output.

## Revendications

1. Convertisseur sigma-delta N/A, par l'intermédiaire duquel un signal d'entrée numérique est convertible en un signal de sortie binaire temporel discret selon un cycle d'horloge (CLK), la valeur du signal d'entrée pouvant être représentée de façon analogique par une valeur moyenne du signal de sortie formée sur plusieurs cycles d'horloge (CLK),
le convertisseur sigma-delta N/A étant conçu de telle sorte à mettre à disposition, lorsqu'il est en fonctionnement, le signal de sortie par la juxtaposition de séquences de signaux ("0" SM, "1" SM, "1/4" SM, "2/4" SM, "3/4" SM, "1/16" SM, "2/16" SM, ..., "15/16" SM) d'un bloc de séquences de signaux, les séquences de signaux du bloc étant binaires, à valeurs discrètes en temps selon le cycle d'horloge (CLK) et s'étendant sur une longueur de séquence de signaux de plusieurs cycles d'horloge, au moins deux séquences de signaux du bloc présentant des valeurs moyennes de séquence de signaux différentes l'une de l'autre, lesquelles valeurs moyennes sont formées sur la longueur respective du cycle de séquence de signaux, toutes les séquences de signaux du bloc présentant pour l'essentiel le même nombre, notamment exactement le même nombre, de fronts (2, 3), et pour lequel toutes les séquences de signaux ("1/4" SM, "2/4" SM, "3/4" SM, "1/16" SM, "2/16" SM, ..., "15/16" SM) du bloc présentent une longueur de séquence de signaux de m cycles d'horloge, **caractérisé en ce que** le bloc comporte m-1 séquences de signaux différentes avec chacune présentant des valeurs moyennes de séquence de signaux différentes, **en ce que** la séquence de signaux ("1/4" SM, "1/16" SM) présentant la valeur moyenne la plus basse prend pendant un cycle la valeur binaire haute parmi les deux valeurs binaires disponibles et, pendant les m-1 cycles restants, la valeur binaire basse, et **en ce que** chaque séquence de signaux du bloc par rapport à la séquence de signaux présentant la valeur moyenne immédiatement inférieure prend la valeur binaire haute pendant exactement un cycle de plus.

2. Convertisseur sigma-delta N/A selon la revendication 1, **caractérisé en ce que** toutes les séquences de signaux ("0" SM, "1" SM, "1/4" SM, "2/4" SM, "3/4" SM, "1/16" SM, "2/16" SM, ..., "15/16" SM) du bloc présentent chacune le même nombre de fronts montants (2) et le même nombre de fronts descendants (3).

3. Convertisseur sigma-delta N/A selon la revendication 1 ou 2, **caractérisé en ce que** toutes les séquences de signaux ("0" SM, "1" SM, "1/4" SM, "2/4" SM, "3/4" SM, "1/16" SM, "2/16" SM, ..., "15/16" SM) du bloc présentent chacune la même longueur de cycle de la séquence de signaux.

4. Convertisseur sigma-delta N/A selon l'une des revendications précédentes, **caractérisé en ce que** toutes les séquences de signaux ("0" SM, "1" SM, "1/4" SM, "2/4" SM, "3/4" SM, "1/16" SM, "2/16" SM, ..., "15/16" SM) du bloc présentent chacune exactement un front montant (2) et exactement un front descendant (3).

5. Convertisseur sigma-delta N/A selon l'une des revendications précédentes, **caractérisé en ce que** toutes les séquences de signaux ("0" SM, "1" SM, "1/4" SM, "2/4" SM, "3/4" SM, "1/16" SM, "2/16" SM, ..., "15/16" SM) du bloc présentent chacune des valeurs moyennes de séquence de signaux différentes.

6. Convertisseur sigma-delta N/A selon l'une des revendications précédentes, **caractérisé en ce que** le convertisseur sigma-delta N/A présente un modulateur sigma-delta numérique (22, 50), par l'intermédiaire duquel une partie du signal d'entrée numérique est modulable.

7. Convertisseur sigma-delta N/A selon la revendication 6, **caractérisé en ce que** le convertisseur sigma-delta N/A est conçu de telle sorte qu'il soit possible de dériver du signal d'entrée numérique un nombre prédéfini parmi les positions de bit de valeur supérieure, et qu'il soit possible d'acheminer les positions de bit restantes au modulateur sigma-delta numérique (50) pour la génération d'un signal de sortie de modulateur binaire à valeurs discrètes en temps selon un cycle modulaire (1/16 CLK).

8. Convertisseur sigma-delta N/A selon la revendication 7, **caractérisé en ce qu'**est définie une affectation, à travers laquelle chaque séquence de signaux ("1/4" SM, "2/4" SM, "3/4" SM, "1/16" SM, "2/16" SM, ..., "15/16" SM) du bloc est affectée à une configuration de la ou des position(s) de bit de valeur supérieure dérivable(s) du signal d'entrée numérique, **en ce que** le convertisseur sigma-delta N/A comporte un générateur de séquences de signaux (52), par l'intermédiaire duquel la séquence de signaux correspondante peut être déterminée en fonction de la configuration respective de la ou des position(s) de bit de valeur supérieure dérivées selon l'affectation, et **en ce que** cette séquence de signaux déterminée peut être sortie à travers le générateur de séquences de signaux (52) en tant que grandeur de modulation inférieure pour la génération du signal de sortie.

9. Convertisseur sigma-delta N/A selon la revendication 8, **caractérisé en ce que** la séquence de signaux ("1/4" SM, "2/4" SM, "3/4" SM, "1/16" SM, "2/16" SM, ..., "15/16" SM) présentant la valeur moyenne de séquence de signaux immédiatement supérieure comparée à la valeur moyenne de la séquence de signaux déterminée en tant que grandeur de modulation supérieure peut être sortie à travers le générateur de séquences de signaux (52) en tant que grandeur de modulation supérieure pour la génération du signal de sortie.

10. Convertisseur sigma-delta N/A selon la revendication 9, **caractérisé en ce que** le signal de sortie du modulateur sigma-delta numérique (50) peut être acheminé au générateur de séquences de signaux (52) et **en ce que** la modulation entre la grandeur de modulation inférieure et la grandeur de modulation supérieure est réalisée en fonction du signal de sortie du modulateur.

11. Utilisation d'un convertisseur sigma-delta N/A (48, 79) selon l'une des revendications précédentes dans un appareil (78) avec une sortie courant ou tension analogique (80) destinée à la conversion d'une valeur de mesure numérique déterminée par l'appareil (78), ou destinée à la conversion d'une valeur de réglage numérique déterminée par l'appareil en un signal de courant ou tension analogique, lequel peut être sorti par l'intermédiaire de la sortie courant ou tension analogique (80).

12. Utilisation selon la revendication 11, **caractérisée en ce qu'**est effectuée la conversion de la valeur de mesure ou de la valeur de réglage en un signal de courant, notamment en un signal de courant selon le standard 4-20 mA.

13. Appareil de mesure avec une sortie courant ou tension analogique (80), comportant un convertisseur sigma-delta N/A (79) selon l'une des revendications 1 à 10, pour lequel une valeur de mesure numérique, déterminée dans l'appareil (78), peut être acheminée en tant que signal d'entrée numérique au convertisseur sigma-delta N/A (79), et pour lequel le signal de sortie du convertisseur sigma-delta N/A peut être sorti pour la génération d'un signal de courant ou de tension analogique correspondant à la valeur de mesure numérique, sur la sortie courant ou tension analogique (80).

14. Appareil de commande avec une sortie courant ou tension analogique, comportant un convertisseur sigma-delta N/A (48) selon l'une des revendications 1 à 10, pour lequel une valeur de réglage numérique, déterminée dans l'appareil de commande, peut être acheminée en tant que signal d'entrée numérique au convertisseur sigma-delta N/A (48), et pour lequel le signal de sortie du convertisseur sigma-delta N/A peut être sorti pour la génération d'un signal de courant ou de tension analogique correspondant à la valeur de réglage numérique sur la sortie courant ou tension analogique.
